# DEMANDE DE BREVET EUROPEEN

(11) **EP 3 758 066 A1**
(43) Date de publication de la demande: **30.12.2020**
(21) Numéro de dépôt: 20182434.9
(22) Date de dépôt: 26.06.2020
(51) Int. Cl.: H01L 27/06, H01L 29/93, H01L 21/8222, H01L 29/66, H01L 29/10

(54) **PROCÉDÉ DE RÉALISATION D'UNE DIODE À CAPACITÉ VARIABLE ET D'UN TRANSISTOR BIPOLAIRE**

(30) Priorité: 28.06.2019 FR 1907150
(71) Demandeur: STMicroelectronics (Crolles 2) SAS, 38920 Crolles (FR)
(72) Inventeur: AVENIER, Gregory, 38330 SAINT NAZAIRE LES EYMES (FR); GAUTHIER, Alexis, 38240 MEYLAN (FR); CHEVALIER, Pascal, 38530 CHAPAREILLAN (FR)
(74) Mandataire: Cabinet Beaumont

(57) **Abrégé**

La présente description concerne un procédé de réalisation, conjointement sur un même substrat (500), d'au moins un transistor bipolaire (HBT) et d'au moins une diode à capacité variable (HA-Varactor).

## Description

### Domaine technique

La présente description concerne de façon générale les procédés de réalisation de composants électroniques et, plus particulièrement, les procédés de réalisation de diodes à capacité variable, également appelées diodes varicap ou encore varactors.

### Technique antérieure

Une diode varicap est un dipôle électronique doté de deux bornes entre lesquelles est formée une jonction p-n.

Lorsqu'elle est soumise à une polarisation directe, la diode varicap présente un fonctionnement analogue à celui d'une diode classique, c'est-à-dire qu'elle devient passante une fois dépassé un certain seuil de tension.

En revanche, si l'on applique à ses bornes une tension de polarisation inverse, la diode varicap se distingue d'une diode classique à l'état bloqué en ce qu'elle se comporte théoriquement non pas comme un circuit ouvert, mais plutôt comme un condensateur. En pratique, un phénomène capacitif similaire se produit aussi, mais dans une moindre mesure, pour une diode classique polarisée en inverse.

Tandis que l'on cherche plutôt à éviter ce phénomène capacitif dans le cas d'une diode classique, on s'efforce de le favoriser autant que possible dans le cas d'une diode varicap.

### Résumé de l'invention

Il existe un besoin d'augmenter la capacité électrique des diodes varicap actuelles. Il existe, en outre, un besoin d'améliorer les procédés permettant de réaliser une diode varicap.

Un mode de réalisation pallie tout ou partie des inconvénients des diodes varicap et de leurs procédés de réalisation connus.

Un mode de réalisation prévoit un procédé de réalisation, conjointement sur un même substrat, d'au moins un transistor bipolaire et d'au moins une diode à capacité variable, le procédé comprenant, préalablement à la formation d'un émetteur dudit transistor bipolaire, une étape de revêtement de ladite diode à capacité variable par une portion d'une couche sacrificielle.

Selon un mode de réalisation, ladite diode comporte une jonction p-n incluant :
une première région d'un premier type de conductivité ; et
une deuxième région d'un deuxième type de conductivité, ladite deuxième région et une base intrinsèque dudit transistor étant réalisées au cours d'une même étape.

Selon un mode de réalisation, ladite deuxième région est réalisée à l'aplomb d'une région de collecteur extrinsèque constituant ladite première région.

Selon un mode de réalisation, ladite deuxième région est réalisée par épitaxie.

Selon un mode de réalisation, ladite diode comporte une troisième région, du premier type de conductivité, intercalée entre ladite première région et ladite deuxième région.

Selon un mode de réalisation, ladite troisième région et un collecteur intrinsèque dudit transistor sont réalisés au cours d'une même étape.

Selon un mode de réalisation, ladite troisième région est réalisée par épitaxie.

Selon un mode de réalisation, le premier type de conductivité est n et le deuxième type de conductivité est p.

Selon un mode de réalisation, le premier type de conductivité est p et le deuxième type de conductivité est n.

Selon un mode de réalisation, ladite diode est un varactor à jonction p-n hyperabrupte.

Un mode de réalisation prévoit un procédé tel que décrit, comportant des étapes consistant à :
prévoir un substrat, à l'intérieur duquel au moins une première région de collecteur extrinsèque comporte des premier et deuxième puits et à l'intérieur duquel au moins une deuxième région de collecteur extrinsèque comporte un troisième puits ;
former un empilement comportant, à partir d'une surface supérieure dudit substrat, des première, deuxième, troisième et quatrième couches ;
pratiquer des première et deuxième ouvertures dans lesdites deuxième, troisième et quatrième couches ;
réaliser des premiers espaceurs à l'intérieur desdites première et deuxième ouvertures ; et
pratiquer des troisième et quatrième ouvertures dans ladite première couche.

Un mode de réalisation prévoit un procédé tel que décrit, comportant des étapes consistant à :
déposer, du côté de ladite surface supérieure, une cinquième couche et ladite couche sacrificielle ;
protéger ladite portion de ladite couche sacrificielle par une zone d'une sixième couche ;
éliminer ladite couche sacrificielle à l'exception de ladite portion de ladite couche sacrificielle et à l'exception de première et deuxième zones de ladite couche sacrificielle ;
éliminer ladite zone de ladite sixième couche ;
éliminer des zones de ladite cinquième couche non recouvertes ;
déposer, du côté de ladite surface supérieure, une septième couche ;
éliminer ladite septième couche à l'exception d'une zone de ladite septième couche recouverte par une zone d'une huitième couche et éliminer ladite portion de ladite couche sacrificielle ;
éliminer des portions de zones de ladite quatrième couche non recouvertes et éliminer ladite zone de ladite huitième couche ;
protéger respectivement la future diode et le futur transistor par des première et deuxième zones d'une neuvième couche et éliminer des portions non protégées de première, deuxième et troisième zones desdites troisième et deuxième couches ;
éliminer des portions de zones de ladite première couche non recouvertes et éliminer lesdites première et deuxième zones de ladite neuvième couche ;
réaliser des deuxièmes espaceurs comblant des angles droits du côté de ladite surface supérieure ; et
réaliser respectivement des premier, deuxième et troisième contacts sur lesdits premier, deuxième et troisième puits, réaliser un troisième contact sur un premier dépôt, réaliser un quatrième contact sur une première portion de ladite zone de ladite deuxième couche, réaliser un cinquième contact sur une deuxième portion de ladite zone de ladite deuxième couche et réaliser un sixième contact sur ladite zone de ladite septième couche.

Un mode de réalisation prévoit un procédé tel que décrit, comportant une étape consistant à combler ladite troisième ouverture par un deuxième dépôt et par ledit premier dépôt et à combler ladite quatrième ouverture par des troisième et quatrième dépôts.

Un mode de réalisation prévoit un procédé tel que décrit, comportant une étape consistant à combler ladite troisième ouverture par ledit premier dépôt et à combler ladite quatrième ouverture par un cinquième dépôt.

Un mode de réalisation prévoit un circuit électronique comportant au moins une diode à capacité variable et au moins un transistor bipolaire, obtenus par le procédé tel que décrit.

### Brève description des dessins

Ces caractéristiques et avantages, ainsi que d'autres, seront exposés en détail dans la description suivante de modes de réalisation et modes de mise en œuvre particuliers faite à titre non limitatif en relation avec les figures jointes parmi lesquelles :
La figure 1 représente, de façon schématique et en coupe, une étape d'un mode de mise en œuvre d'un procédé de réalisation d'une diode varicap ;
La figure 2 représente, de façon schématique et en coupe, une autre étape du mode de mise en œuvre du procédé de réalisation d'une diode varicap ;
La figure 3 représente, de façon schématique et en coupe, encore une autre étape du mode de mise en œuvre du procédé de réalisation d'une diode varicap ;
La figure 4 représente, de façon schématique et en coupe, encore une autre étape du mode de mise en œuvre du procédé de réalisation d'une diode varicap ;
La figure 5 représente, de façon schématique et en coupe, encore une autre étape du mode de mise en œuvre du procédé de réalisation d'une diode varicap ;
La figure 6 représente, de façon schématique et en coupe, encore une autre étape du mode de mise en œuvre du procédé de réalisation d'une diode varicap ;
La figure 7 représente, de façon schématique et en coupe, une variante du mode de mise en œuvre du procédé de réalisation d'une diode varicap ;
La figure 8 représente, de façon schématique et en coupe, encore une autre étape du mode de mise en œuvre du procédé de réalisation d'une diode varicap ;
La figure 9 représente, de façon schématique et en coupe, encore une autre étape du mode de mise en œuvre du procédé de réalisation d'une diode varicap ;
La figure 10 représente, de façon schématique et en coupe, encore une autre étape du mode de mise en œuvre du procédé de réalisation d'une diode varicap ;
La figure 11 représente, de façon schématique et en coupe, encore une autre étape du mode de mise en œuvre du procédé de réalisation d'une diode varicap ;
La figure 12 représente, de façon schématique et en coupe, encore une autre étape du mode de mise en œuvre du procédé de réalisation d'une diode varicap ;
La figure 13 représente, de façon schématique et en coupe, encore une autre étape du mode de mise en œuvre du procédé de réalisation d'une diode varicap ;
La figure 14 représente, de façon schématique et en coupe, encore une autre étape du mode de mise en œuvre du procédé de réalisation d'une diode varicap ;
La figure 15 représente, de façon schématique et en coupe, encore une autre étape du mode de mise en œuvre du procédé de réalisation d'une diode varicap ;
La figure 16 représente, de façon schématique et en coupe, encore une autre étape du mode de mise en œuvre du procédé de réalisation d'une diode varicap ;
La figure 17 représente, de façon schématique et en coupe, encore une autre étape du mode de mise en œuvre du procédé de réalisation d'une diode varicap ;
La figure 18 représente, de façon schématique et en coupe, encore une autre étape du mode de mise en œuvre du procédé de réalisation d'une diode varicap ; et
La figure 19 représente des courbes de variation d'une grandeur caractéristique des diodes varicap obtenues selon le mode de mise en œuvre du procédé tel que décrit.

### Description des modes de réalisation

De mêmes éléments ont été désignés par de mêmes références dans les différentes figures. En particulier, les éléments structurels et/ou fonctionnels communs aux différents modes de réalisation et modes de mise en œuvre peuvent présenter les mêmes références et peuvent disposer de propriétés structurelles, dimensionnelles et matérielles identiques.

Par souci de clarté, seuls les étapes et éléments utiles à la compréhension des modes de réalisation et modes de mise en œuvre décrits ont été représentés et sont détaillés. En particulier, le procédé de préparation du substrat n'est pas détaillé.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

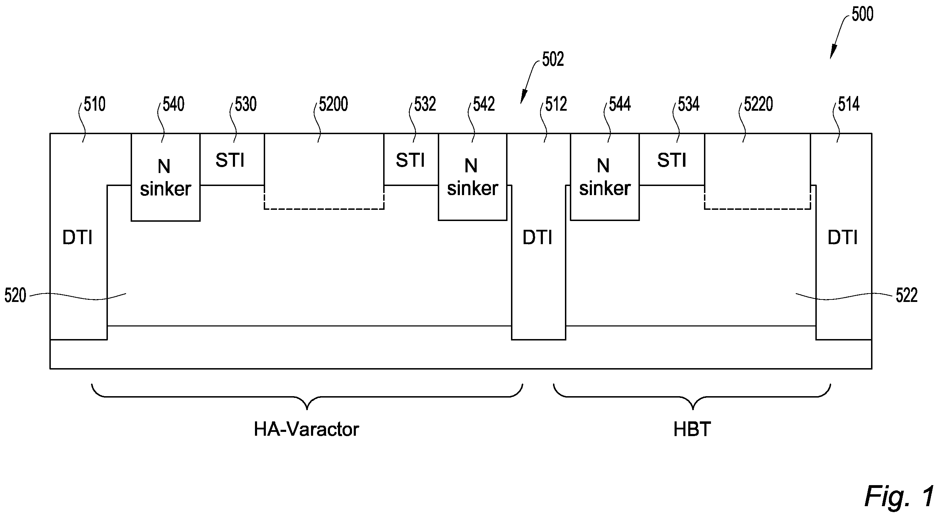

Les figures 1 à 18 ci-dessous illustrent des étapes successives d'un même mode de mise en œuvre d'un procédé de réalisation d'une diode varicap 100 ou diode à capacité variable 100 ou varistor 100. Selon ce mode de mise en œuvre, la diode varicap 100 est co-intégrée avec un transistor 300 bipolaire à hétérojonction (Heterojunction Bipolar Transistor - HBT), ici un transistor 300 de type BiCMOS (Bipolar CMOS). En d'autres termes, le mode de mise en œuvre décrit permet la réalisation, sur un même substrat et de façon conjointe, d'un transistor bipolaire 300 et d'une diode varicap 100.

Pour simplifier, ce qui est exposé ci-dessous en relation avec les figures 1 à 18 prend pour exemple un procédé dans lequel une seule diode à capacité variable 100 et un seul transistor bipolaire 300 sont conjointement réalisés. Néanmoins, il est entendu que ce procédé peut être étendu à la réalisation, conjointe et sur un même substrat, d'un nombre quelconque de transistors bipolaires 300 et d'un nombre quelconque de diodes à capacité variable 100, ces deux nombres pouvant être différents.

La figure 1 représente, de façon schématique et en coupe, une étape d'un mode de mise en œuvre d'un procédé de réalisation d'une diode varicap.

Selon ce mode de mise en œuvre, on commence par prévoir un substrat 500 constitué, par exemple, d'une plaquette de silicium monocristallin. En figure 1, le substrat 500 comporte une première région 520 de collecteur extrinsèque et une deuxième région 522 de collecteur extrinsèque. Ces régions 520 et 522 de collecteur extrinsèque sont, par exemple, réalisées par une opération d'implantation ionique très fortement dosée (d'environ 10¹⁵ at/cm2) dans le substrat 500, suivie d'une opération d'épitaxie sur une épaisseur d'environ 0,4 µm.

En figure 1, le substrat 500 comporte en outre des premières structures isolantes 510, 512 et 514 (DTI - Deep Trench Isolation), par exemple des tranchées ou rainures d'isolation profondes. Ces tranchées d'isolation profondes 510, 512 et 514 s'étendent verticalement depuis une surface supérieure 502 du substrat 500. De gauche à droite en figure 1, les tranchées 510, 512 et 514 délimitent ainsi latéralement, dans le substrat 500, deux emplacements :
un premier emplacement (HA-Varactor), compris entre les tranchées 510 et 512 (à gauche, en figure 1), où l'on souhaite réaliser la diode à capacité variable 100, désigné ci-après par l'expression « emplacement de la diode » ; et
un deuxième emplacement (HBT), compris entre les tranchées 512 et 514 (à droite, en figure 1), où l'on souhaite réaliser le transistor bipolaire 300, désigné ci-après par l'expression « emplacement du transistor ».

Les tranchées d'isolation profondes 510, 512 et 514 du substrat 500 séparent, en figure 1, les deux régions 520 et 522 de collecteur extrinsèque. Les régions 520 et 522 s'étendent verticalement, depuis la surface supérieure 502 du substrat 500, jusqu'à une profondeur inférieure à celle des tranchées d'isolation profondes 510, 512 et 514. Plus précisément :
la première région 520 de collecteur extrinsèque, située à l'emplacement de la diode, est intercalée entre les tranchées d'isolation profondes 510 et 512 ; et
la deuxième région 522 de collecteur extrinsèque, située à l'emplacement du transistor, est intercalée entre les tranchées d'isolation profondes 512 et 514.

Les première et deuxième régions 520, 522 de collecteur extrinsèque sont donc séparées l'une de l'autre par une tranchée d'isolation commune, en l'occurrence la tranchée d'isolation profonde 512 comme illustré en figure 1. Ces régions 520 et 522 sont, par exemple, obtenues par implantation ionique, sous la surface supérieure 502 du substrat 500, d'un élément dopant d'un premier type de conductivité, par exemple de type n. Les première et deuxième régions 520, 522 de collecteur extrinsèque possèdent alors une concentration en élément dopant d'autant plus forte que l'on s'éloigne de la surface supérieure 502 du substrat 500.

Selon un mode de mise en œuvre préféré, une zone 5200 (représentée en pointillés, en figure 1), appartenant à la première région 520 de collecteur extrinsèque et située sous la surface supérieure 502 du substrat 500, subit une implantation ionique supplémentaire d'un élément dopant du premier type de conductivité, ici du type n. Cette opération est par exemple effectuée par implantation ionique d'arsenic (ions As⁺) avec une énergie de 130 keV, en vue d'obtenir un dopage surfacique de l'ordre de 6.10¹³ at/cm².

De même, une zone 5220 (représentée en pointillés, en figure 1), appartenant à la deuxième région 522 de collecteur extrinsèque et située sous la surface supérieure 502 du substrat 500, subit une implantation ionique similaire. Les implantations ioniques permettant de former les zones 5200 et 5220 sont, de préférence, effectuées en même temps.

Le substrat 500 comporte, en outre, des deuxièmes structures isolantes 530, 532 et 534 (STI - Shallow Trench Isolation), par exemple des tranchées ou rainures d'isolation peu profondes. Ces tranchées d'isolation peu profondes 530, 532 et 534 s'étendent verticalement, depuis la surface supérieure 502 du substrat 500, jusqu'à une profondeur moindre que celle des régions 520 et 522.

À l'emplacement de la diode, les tranchées 530 et 532 bordent ou jouxtent la zone 5200 de la région 520. Les tranchées 530 et 532 sont donc situées de part et d'autre de la zone 5200 (en figure 1, les tranchées 530 et 532 sont respectivement accolées aux côtés gauche et droit de la zone 5200) .

À l'emplacement du transistor, la tranchée 534 borde la zone 5220 de la région 522 (en figure 1, la tranchée 534 est accolée au côté gauche de la zone 5220). Les tranchées d'isolation peu profondes 530, 532 et 534 possèdent une profondeur d'environ 300 nm, de préférence égale à 300 nm.

Le substrat 500 comporte, par ailleurs, des premier, deuxième et troisième puits 540, 542 et 544 (N sinker) qui s'étendent verticalement, depuis la surface supérieure 502 du substrat 500, jusqu'à une profondeur supérieure à celle des zones 5200, 5220 et inférieure à celle des régions 520 et 522. Ces puits 540, 542 et 544 sont du premier type de conductivité, ici du type n.

À l'emplacement de la diode, le premier puits 540 est intercalé entre la tranchée d'isolation profonde 510 et la tranchée d'isolation peu profonde 530 (en figure 1, les tranchées 510 et 530 sont respectivement accolées aux côtés gauche et droit du puits 540). Le deuxième puits 542 est intercalé entre la tranchée d'isolation peu profonde 532 et la tranchée d'isolation profonde 512 (en figure 1, les tranchées 532 et 512 sont respectivement accolées aux côtés gauche et droit du puits 542). Les premier et deuxième puits 540 et 542 permettent ainsi de contacter la première région 520 de collecteur extrinsèque depuis la surface supérieure 502 du substrat 500.

À l'emplacement du transistor, le troisième puits 544 est intercalé entre la tranchée d'isolation profonde 512 et la tranchée d'isolation peu profonde 534 (en figure 1, les tranchées 512 et 534 sont respectivement accolées aux côtés gauche et droit du puits 544). Le troisième puits 544 permet ainsi de contacter la deuxième région 522 de collecteur extrinsèque depuis la surface supérieure 502 du substrat 500.

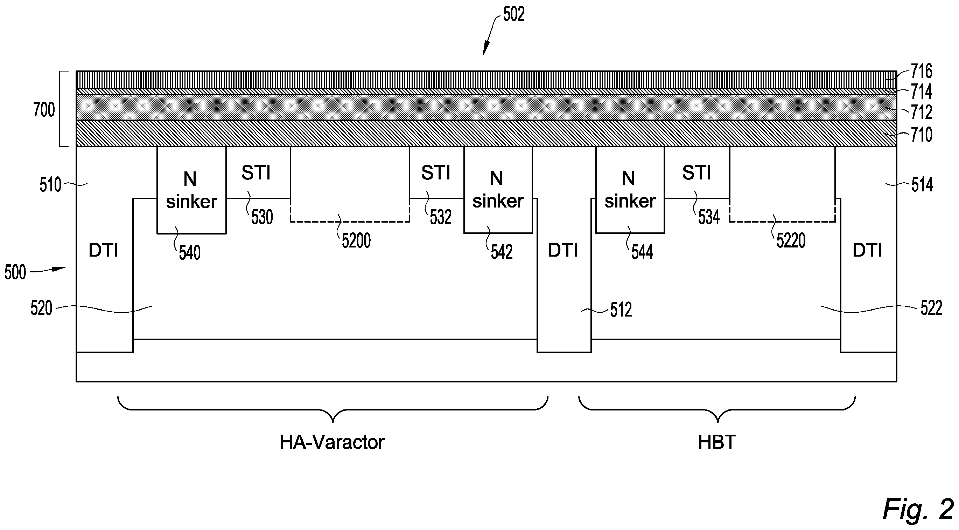

Dans la suite de la description, le mode de mise en œuvre du procédé décrit en relation avec les figures 2 à 18 consiste exclusivement à réaliser des opérations au-dessus de la surface supérieure 502 du substrat 500. Le substrat 500 des figures 2 à 18 est donc de préférence identique au substrat 500 tel qu'exposé en relation avec la figure 1 pendant tout le procédé. Pour simplifier, le substrat 500 ne sera donc pas à nouveau détaillé dans les figures ci-dessous.

La figure 2 représente, de façon schématique et en coupe, une autre étape du mode de mise en œuvre du procédé de réalisation d'une diode varicap, réalisée à partir de la structure telle que décrite en relation avec la figure 1.

Au cours de cette étape, un premier empilement vertical 700 de quatre couches successives reposant les unes sur les autres est déposé sur toute la surface supérieure 502 du substrat 500. Ce premier empilement 700 comporte plus précisément :
une première couche 710 constituée d'un oxyde, par exemple un oxyde de silicium, recouvrant intégralement la surface supérieure 502 du substrat 500 ;
une deuxième couche 712 constituée de silicium polycristallin d'un deuxième type de conductivité, ici du type p, recouvrant intégralement la surface supérieure de la première couche 710 ;
une troisième couche 714 constituée d'un oxyde, par exemple le même oxyde que celui dont est constituée la première couche 710, recouvrant intégralement la surface supérieure de la deuxième couche 712 ; et
une quatrième couche 716 constituée d'un nitrure, par exemple un nitrure de silicium, recouvrant intégralement la surface supérieure de la troisième couche 714.

Selon ce mode de mise en œuvre, les couches 710, 712, 714 et 716 constitutives de l'empilement 700 présentent des épaisseurs différentes. Par exemple :
la première couche 710 possède une épaisseur comprise entre 30 nm et 70 nm, de préférence d'environ 50 nm, plus préférentiellement égale à 50 nm ;
la deuxième couche 712 possède une épaisseur comprise entre 20 nm et 60 nm, de préférence d'environ 40 nm, plus préférentiellement égale à 40 nm ;
la troisième couche 714 possède une épaisseur comprise entre 2 nm et 8 nm, de préférence d'environ 5 nm, plus préférentiellement égale à 5 nm ; et
la quatrième couche 716 possède une épaisseur comprise entre 20 nm et 60 nm, de préférence d'environ 40 nm, plus préférentiellement égale à 40 nm.

Les couches 710, 712, 714 et 716 de l'empilement 700 ne sont pas représentées à l'échelle en figure 2.

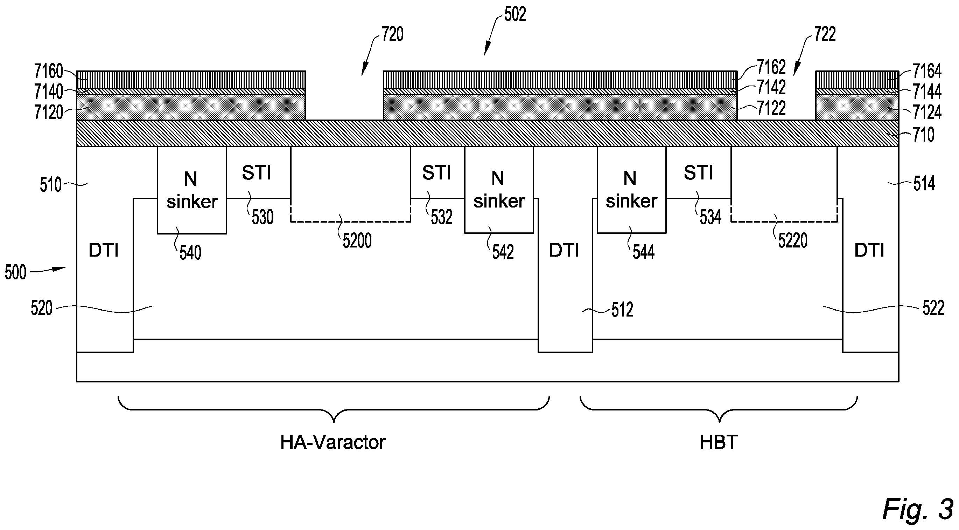

La figure 3 représente, de façon schématique et en coupe, encore une autre étape du mode de mise en œuvre du procédé de réalisation d'une diode varicap, réalisée à partir de la structure telle que décrite en relation avec la figure 2.

Au cours de cette étape, on grave localement l'empilement 700 à l'aplomb des zones 5200 et 5220 jusqu'à la surface supérieure de la première couche 710. Cela revient à pratiquer, à travers les quatrième, troisième et deuxième couches 716, 714 et 712 :
une première ouverture verticale 720, située à l'emplacement de la diode ; et
une deuxième ouverture verticale 722, située à l'emplacement du transistor.

Selon un mode de mise en œuvre préféré, la largeur de la première ouverture 720 est inférieure à celle de la zone 5200 et la largeur de la deuxième ouverture 722 est inférieure à celle de la zone 5222. Les première et deuxième ouvertures 720 et 722 sont approximativement centrées par rapport aux zones 5200 et 5220, respectivement.

Dans l'exemple de la figure 3, la deuxième couche 712 est séparée en des première, deuxième et troisième zones 7120, 7122 et 7124. Plus précisément :
les zones 7120 et 7122 sont situées de part et d'autre de l'ouverture 720 (en figure 3, la zone 7120 est située à gauche de l'ouverture 720 tandis que la zone 7122 est située à droite de l'ouverture 720) ; et
les zones 7122 et 7124 sont situées de part et d'autre de l'ouverture 722 (en figure 3, la zone 7122 est située à gauche de l'ouverture 722 tandis que la zone 7124 est située à droite de l'ouverture 722).

Toujours dans l'exemple de la figure 3, la troisième couche 714 est séparée en des première, deuxième et troisième zones 7140, 7142 et 7144. Plus précisément :
les zones 7140 et 7142 sont situées de part et d'autre de l'ouverture 720 (en figure 3, la zone 7140 est située à gauche de l'ouverture 720 tandis que la zone 7142 est située à droite de l'ouverture 720) ; et
les zones 7142 et 7144 sont situées de part et d'autre de l'ouverture 722 (en figure 3, la zone 7142 est située à gauche de l'ouverture 722 tandis que la zone 7144 est située à droite de l'ouverture 722).

Toujours dans l'exemple de la figure 3, la quatrième couche 716 est séparée en des première, deuxième et troisième zones 7160, 7162 et 7164. Plus précisément :
les zones 7160 et 7162 sont situées de part et d'autre de l'ouverture 720 (en figure 3, la zone 7160 est située à gauche de l'ouverture 720 tandis que la zone 7162 est située à droite de l'ouverture 720) ; et
les zones 7162 et 7164 sont situées de part et d'autre de l'ouverture 722 (en figure 3, la zone 7162 est située à gauche de l'ouverture 722 tandis que la zone 7164 est située à droite de l'ouverture 722).

Les deuxièmes zones 7122, 7142 et 7162 des couches 712, 714 et 716, respectivement, sont donc intercalées entre les deux ouvertures 720 et 722. La première couche 710 demeure intacte tout au long de l'étape décrite en relation avec la figure 3.

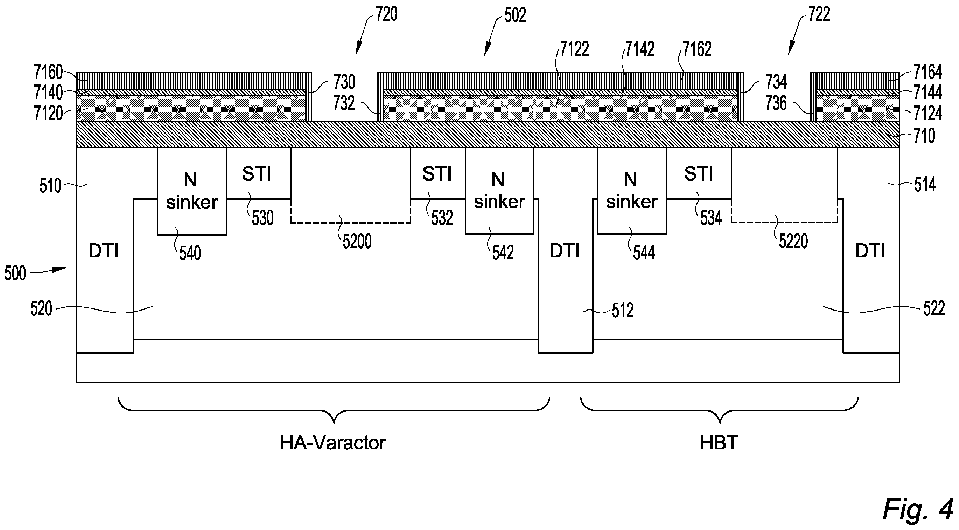

La figure 4 représente, de façon schématique et en coupe, encore une autre étape du mode de mise en œuvre du procédé de réalisation d'une diode varicap, réalisée à partir de la structure telle que décrite en relation avec la figure 3.

Au cours de cette étape, des premiers espaceurs 730, 732, 734 et 736 sont réalisés à l'intérieur des ouvertures 720 et 722 préalablement pratiquées dans l'empilement 700. Les espaceurs 730 et 732 bordent intégralement les parois latérales de l'ouverture 720. De la même façon, les espaceurs 734 et 736 bordent intégralement les parois latérales de l'ouverture 722. Plus précisément, en figure 4 :
l'espaceur 730 couvre totalement les faces latérales des premières zones 7120, 7140 et 7160 des couches 712, 714 et 716 qui constituent des parois internes de l'ouverture 720 ;
l'espaceur 732 couvre totalement les faces latérales des deuxièmes zones 7122, 7142 et 7162 des couches 712, 714 et 716 qui constituent des parois internes de l'ouverture 720 ;
l'espaceur 734 couvre totalement les faces latérales des deuxièmes zones 7122, 7142 et 7162 des couches 712, 714 et 716 qui constituent des parois internes de l'ouverture 722 ; et
l'espaceur 736 couvre totalement les faces latérales des troisièmes zones 7124, 7144 et 7164 des couches 712, 714 et 716 qui constituent des parois internes de l'ouverture 722.

Les espaceurs 730 et 732 sont non jointifs, c'est-à-dire qu'ils ne recouvrent que partiellement la surface supérieure libre de la première couche 710 au fond de la première ouverture 720. De même, les espaceurs 734 et 736 sont non jointifs, c'est-à-dire qu'ils ne recouvrent que partiellement la surface supérieure libre de la première couche 710 au fond de la deuxième ouverture 722.

Les premiers espaceurs 730, 732, 734 et 736 affleurent la surface supérieure des première, deuxième et troisième zones 7160, 7162 et 7164 de la quatrième couche 716.

Ces premiers espaceurs 730, 732, 734 et 736 sont constitués de nitrure, par exemple le même nitrure que celui dont est constituée la quatrième couche 716. Le cas échéant, on peut considérer que :
l'espaceur 730 prolonge la première zone 7160 de la quatrième couche 716 sur toute une paroi latérale de l'ouverture 720 (en figure 4, la paroi latérale gauche de l'ouverture 720) ;
l'espaceur 732 prolonge la deuxième zone 7162 de la quatrième couche 716 sur toute l'autre paroi latérale de l'ouverture 720 (en figure 4, la paroi latérale droite de l'ouverture 720) ;
l'espaceur 734 prolonge la deuxième zone 7162 de la quatrième couche 716 sur toute une paroi latérale de l'ouverture 722 (en figure 4, la paroi latérale gauche de l'ouverture 722) ; et
l'espaceur 736 prolonge la troisième zone 7164 de la quatrième couche 716 sur toute l'autre paroi latérale de l'ouverture 722 (en figure 4, la paroi latérale droite de l'ouverture 722).

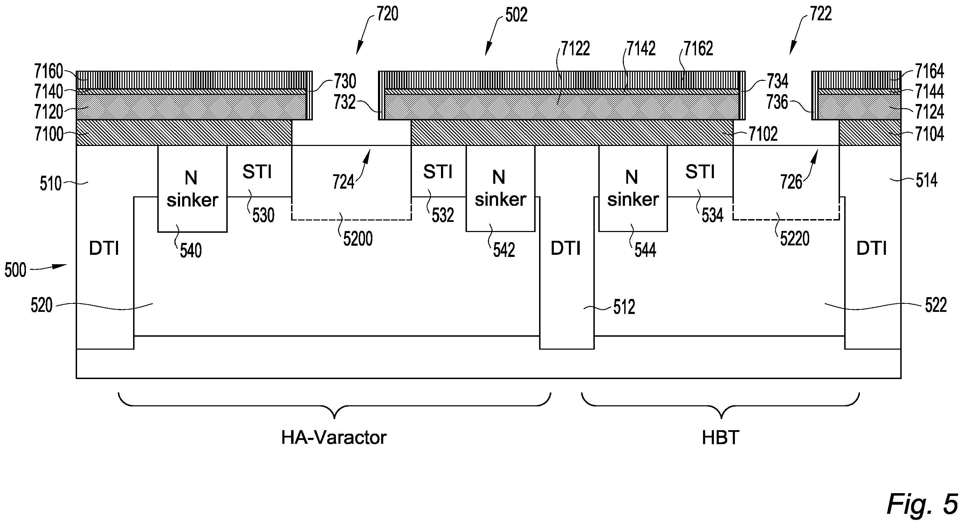

La figure 5 représente, de façon schématique et en coupe, encore une autre étape du mode de mise en œuvre du procédé de réalisation d'une diode varicap, réalisée à partir de la structure telle que décrite en relation avec la figure 4.

Au cours de cette étape, on grave localement la première couche 710 à l'aplomb des zones 5200 et 5220 jusqu'à la surface supérieure 502 du substrat 500. Cela revient à pratiquer, dans la première couche 710 :
une troisième ouverture verticale 724, située à l'emplacement de la diode ; et
une quatrième ouverture verticale 726, située à l'emplacement du transistor.

Selon ce mode de mise en œuvre, la largeur de la troisième ouverture 724 est supérieure à celle de la première ouverture 720 et la largeur de la quatrième ouverture 726 est supérieure à celle de la deuxième ouverture 722. La largeur de la troisième ouverture 724 est, de préférence, égale à celle de la zone 5200 de la première région 520 de collecteur extrinsèque. De la même façon, la largeur de la quatrième ouverture 726 est, de préférence, égale à celle de la zone 5220 de la deuxième région 522 de collecteur extrinsèque. Les troisième et quatrième ouvertures 724 et 726 sont approximativement centrées par rapport aux zones 5200 et 5220, respectivement.

En d'autres termes, cela revient à prolonger respectivement les première et deuxième ouvertures 720 et 722 par les troisième et quatrième ouvertures 724 et 726, pratiquées dans la première couche 710. On vient ainsi désoxyder (c'est-à-dire supprimer l'oxyde) des parties de la surface supérieure 502 du substrat 500 où affleurent les première et deuxième zones 5200 et 5220 des régions 520 et 522 de collecteur extrinsèque. L'oxyde est, de préférence, retiré localement par un procédé de gravure humide.

Dans l'exemple de la figure 5, la première couche 710 est séparée en des première, deuxième et troisième zones 7100, 7102 et 7104. Plus précisément :
les zones 7100 et 7102 sont situées de part et d'autre de l'ouverture 724 (en figure 5, la zone 7100 est située à gauche de l'ouverture 724 tandis que la zone 7102 est située à droite de l'ouverture 724) ; et
les zones 7102 et 7104 sont situées de part et d'autre de l'ouverture 726 (en figure 5, la zone 7102 est située à gauche de l'ouverture 726 tandis que la zone 7104 est située à droite de l'ouverture 726).

La deuxième zone 7102 de la première couche 710 est donc intercalée entre les deux ouvertures 724 et 726.

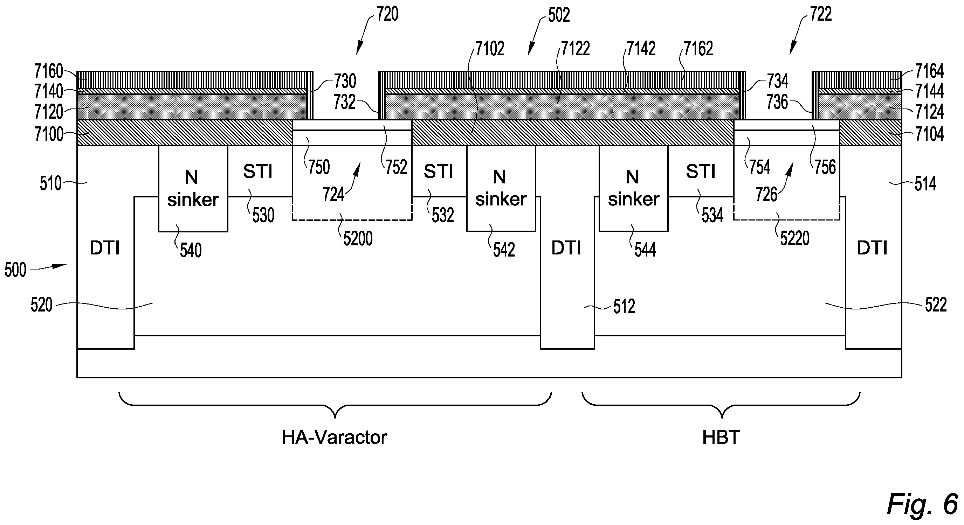

La figure 6 représente, de façon schématique et en coupe, encore une autre étape du mode de mise en œuvre du procédé de réalisation d'une diode varicap, réalisée à partir de la structure telle que décrite en relation avec la figure 5.

Au cours de cette étape, on remplit (on comble) intégralement la troisième ouverture 724 :
par un premier dépôt 750, formant une région 750 recouvrant la totalité de la surface supérieure de la zone 5200 appartenant à la première région 520 de collecteur extrinsèque ; et
par un deuxième dépôt 752, formant une région 752 recouvrant la totalité de la surface supérieure du premier dépôt 750.

De même, au cours de cette étape, on remplit intégralement la quatrième ouverture 726 :
par un troisième dépôt 754, recouvrant la totalité de la surface supérieure de la zone 5220 appartenant à la deuxième région 522 de collecteur extrinsèque ; et
par un quatrième dépôt 756, recouvrant la totalité de la surface supérieure du troisième dépôt 754.

Dans cet exemple :
les premier et deuxième dépôts 750 et 752 sont intercalés entre les première et deuxième zones 7100 et 7102 de la première couche 710 ; et
les troisième et quatrième dépôts 754 et 756 sont intercalés entre les deuxième et troisième zones 7102 et 7104 de la première couche 710.

En figure 6, les premier et deuxième dépôts 750 et 752 présentent conjointement une épaisseur totale sensiblement égale à celle des zones 7100, 7102 et 7104 de la première couche 710, de préférence égale à celle des zones 7100, 7102 et 7104 de la première couche 710. De même, en figure 6, les troisième et quatrième dépôts 754 et 756 présentent conjointement une épaisseur totale sensiblement égale à celle des zones 7100, 7102 et 7104 de la première couche 710, de préférence égale à celle des zones 7100, 7102 et 7104 de la première couche 710.

En d'autres termes, les premier et troisième dépôts 750 et 754 présentent chacun une épaisseur inférieure à celle des zones 7100, 7102 et 7104 de la première couche 710. Les deuxième et quatrième dépôts 752 et 756 illustrés en figure 6 présentent eux aussi chacun une épaisseur inférieure à celle des zones 7100, 7102 et 7104 de la première couche 710.

Le premier dépôt 750 est environ deux fois moins épais que le deuxième dépôt 752, de préférence deux fois moins épais que le deuxième dépôt 752. De même, le troisième dépôt 754 est environ deux fois moins épais que le quatrième dépôt 756, de préférence deux fois moins épais que le quatrième dépôt 756.

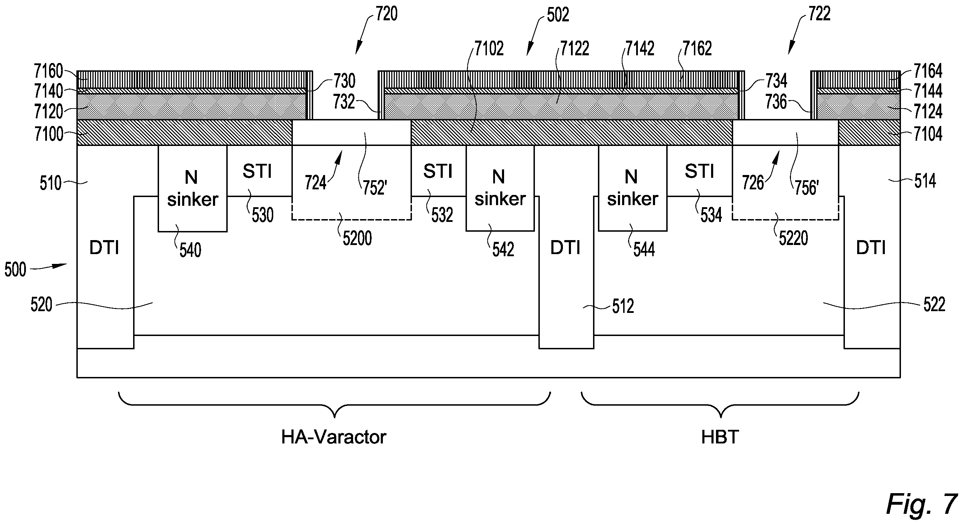

Le premier dépôt 750, le deuxième dépôt 752, le troisième dépôt 754 et le quatrième dépôt 756 ne sont pas représentés à l'échelle en figure 6 et dans les figures 7 à 18 ci-dessous.

L'épaisseur des dépôts 750 et 754 est, dans cet exemple, d'environ 16,7 nm, de préférence égale à 16,7 nm. L'épaisseur des dépôts 752 et 756 est, dans cet exemple, d'environ 33,3 nm, de préférence égale à 33,3 nm.

Les premier et troisième dépôts 750 et 754 sont constitués d'un matériau dopé du premier type de conductivité, ici du type n. Ces premier et troisième dépôts 750 et 754 sont, de préférence, constitués du même matériau que celui dont sont constituées les zones 5200 et 5220 des première et deuxième régions 520 et 522 de collecteur extrinsèque.

Les deuxième et quatrième dépôts 752 et 756 sont constitués d'un matériau dopé du deuxième type de conductivité, ici du type p. Ces deuxième et quatrième dépôts 752 et 756 sont, de préférence, constitués du même matériau que celui dont est constituée la deuxième couche 712 à la différence près que le deuxième dépôt 752 et le quatrième dépôt 756 sont préférentiellement constitués de matériau monocristallin tandis que la deuxième couche 712 est constituée de matériau polycristallin.

Le deuxième dépôt 752 forme donc, avec le premier dépôt 750 situé à l'emplacement de la diode, une première jonction p-n. De même, le quatrième dépôt 756 forme, avec le troisième dépôt 754 situé à l'emplacement du transistor, une deuxième jonction p-n.

Les dépôts 750, 752, 754 et 756 sont, de préférence, réalisés par épitaxie (autrement dit, ils sont obtenus par croissance épitaxiale). En particulier :
les premier et troisième dépôts 750 et 754 peuvent être réalisés en même temps ; et
les deuxième et quatrième dépôts 752 et 756 peuvent être réalisés en même temps, après avoir réalisé les dépôts 750 et 754.

On obtient ainsi une interface très marquée entre le premier dépôt 750 et le deuxième dépôt 752. Cela permet de faire en sorte que la première jonction p-n soit caractérisée par un profil de dopants variant de manière très importante au voisinage de cette interface. On parle alors de jonction p-n « abrupte », autrement dit d'une jonction p-n présentant des profils de dopants abrupts au voisinage de l'interface.

De même, on obtient ainsi une interface très marquée entre le troisième dépôt 754 et le quatrième dépôt 756. Cela permet de faire en sorte que la deuxième jonction p-n soit caractérisée par un profil de dopants variant de manière très importante au voisinage de cette interface (jonction p-n « abrupte »).

Selon ce mode de mise en œuvre, la zone 5220 de la deuxième région 522 de collecteur extrinsèque et le troisième dépôt 754 constituent tous deux un collecteur intrinsèque du futur transistor bipolaire 300. Le quatrième dépôt 756 constitue quant à lui une base intrinsèque du futur transistor bipolaire 300.

La figure 7 représente, de façon schématique et en coupe, une variante du mode de mise en œuvre du procédé de réalisation d'une diode varicap, réalisée à partir de la structure telle que décrite en relation avec la figure 5.

Cette variante diffère principalement de l'étape exposée en relation avec la figure 6 en ce que les troisième et quatrième ouvertures 724 et 726 sont ici respectivement remplies (ou comblées) en totalité par des cinquième et sixième dépôts 752' et 756'. Ces dépôts 752' et 756' sont, de préférence, de même nature que les deuxième et quatrième dépôts 752 et 756 précédemment décrits. Le cinquième dépôt 752' forme ainsi une région 752' de même nature que la région 752. En d'autres termes, cela équivaut à une situation dans laquelle les premier et troisième dépôts 750 et 754 ne sont pas réalisés et où les troisième et quatrième ouvertures 724 et 726 sont intégralement comblées par les deuxième et quatrième dépôts 752 et 756, respectivement.

Ainsi, selon cette variante, les dépôts 752' et 756' recouvrent respectivement la totalité des surfaces supérieures des zones 5200 et 5220 appartenant aux première et deuxième régions 520 et 522 de collecteur extrinsèque. En figure 7 :
le cinquième dépôt 752' est intercalé entre les première et deuxième zones 7100 et 7102 de la première couche 710 ; et
le sixième dépôt 756' est intercalé entre les deuxième et troisième zones 7102 et 7104 de la première couche 710.

Le cinquième dépôt 752' présente, en figure 7, une épaisseur qui équivaut sensiblement à l'épaisseur totale des premier et deuxième dépôts 750 et 752 de la figure 6. De même, le sixième dépôt 756' présente, toujours en figure 7, une épaisseur qui équivaut sensiblement à l'épaisseur totale des troisième et quatrième dépôts 754 et 756 de la figure 6. Ainsi, les cinquième et sixième dépôts 752' et 756' illustrés en figure 7 présentent une épaisseur supérieure à celle des deuxième et quatrième dépôts 752 et 756 illustrés en figure 6.

Les dépôts 752' et 756' présentent ici une épaisseur sensiblement égale à celle des zones 7100, 7102 et 7104 de la première couche 710. L'épaisseur des dépôts 752' et 756' est, dans cet exemple, d'environ 50 nm, de préférence égale à 50 nm.

Les cinquième et sixième dépôts 752' et 756' sont constitués d'un matériau dopé du deuxième type de conductivité, ici du type p. Ces cinquième et sixième dépôts 752' et 756' sont, de préférence, constitués du même matériau que celui dont sont constitués les deuxième et quatrième dépôts 752 et 756 exposés en relation avec la figure 6.

Le cinquième dépôt 752' forme donc, avec la première région 520 de collecteur extrinsèque située à l'emplacement de la diode, une première jonction p-n. De même, le sixième dépôt 756' forme, avec la deuxième région 522 de collecteur extrinsèque située à l'emplacement du transistor, une deuxième jonction p-n.

Plus précisément, selon le mode de mise en œuvre préféré où les première et deuxième régions 520 et 522 de collecteur extrinsèque comportent respectivement des zones 5200 et 5220 :
le cinquième dépôt 752' forme, avec la zone 5200 de la première région 520 de collecteur extrinsèque, la première jonction p-n ; et
le sixième dépôt 756' forme, avec la zone 5220 de la deuxième région 522 de collecteur extrinsèque, la deuxième jonction p-n.

Selon cette variante, le sixième dépôt 756' constitue donc une base intrinsèque du futur transistor bipolaire 300. La zone 5220 de la deuxième région 522 de collecteur extrinsèque constitue un collecteur intrinsèque du futur transistor bipolaire 300.

Les cinquième et sixième dépôts 752' et 756' sont, de préférence, réalisés par épitaxie (autrement dit, ils sont obtenus par croissance épitaxiale).

Par rapport au mode de mise en œuvre illustré en relation avec la figure 6, cette variante a l'avantage de ne pas comporter d'opération de réalisation des premier et troisième dépôts 750 et 754. On réduit ainsi le nombre total d'étapes du procédé, donc le temps alloué à sa mise en œuvre.

On obtient, toujours selon cette variante, une interface marquée entre le cinquième dépôt 752' et la zone 5200 (c'est-à-dire entre le cinquième dépôt 752' et la première région 520 de collecteur extrinsèque). Cela permet de faire en sorte que la première jonction p-n soit caractérisée par un profil de dopants variant de manière importante au voisinage de cette interface (jonction p-n abrupte).

On obtient également une interface marquée entre le sixième dépôt 756' et la zone 5200 (c'est-à-dire entre le sixième dépôt 756' et la première région 520 de collecteur extrinsèque). Cela permet de faire en sorte que la deuxième jonction p-n soit caractérisée par un profil de dopants variant de manière importante au voisinage de cette interface (jonction p-n abrupte).

On suppose par la suite que la variante exposée en relation avec la figure 7 n'est pas retenue dans le mode de mise en œuvre du procédé décrit. Toutefois, l'adaptation des étapes qui suivent à un cas où les premier et troisième dépôts 750 et 754 ne sont pas présents, c'est-à-dire lorsque les troisième et quatrième ouvertures 724 et 726 sont respectivement comblées par des dépôts 752' et 756' comme exposé en relation avec la figure 7 (ou comblées uniquement par des dépôts 752 et 756, respectivement), est à la portée de l'homme du métier à partir des indications fournies ci-dessous.

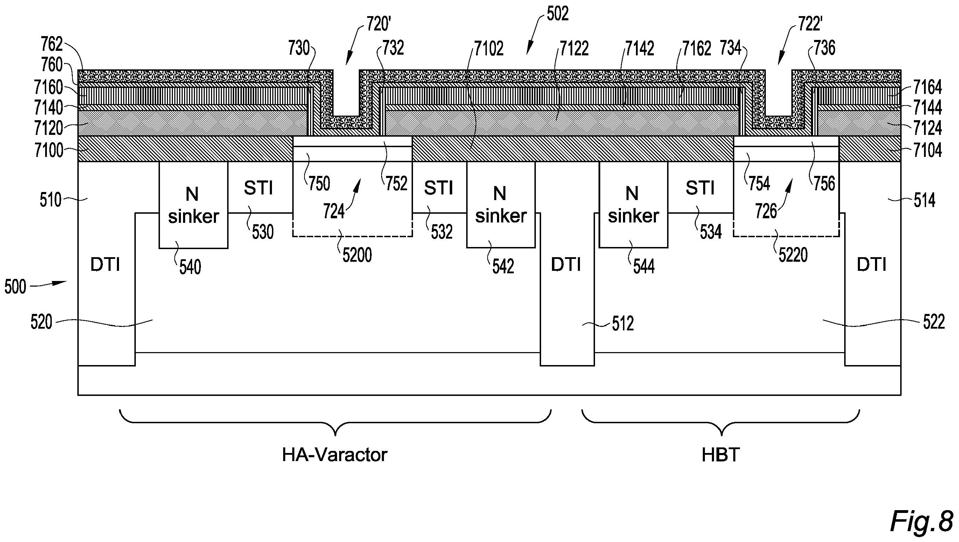

La figure 8 représente, de façon schématique et en coupe, encore une autre étape du mode de mise en œuvre du procédé de réalisation d'une diode varicap, réalisée à partir de la structure telle que décrite en relation avec la figure 7.

Au cours de cette étape sont déposées sur la structure, du côté de la surface supérieure 502 du substrat 500 (en haut, en figure 8) :
une cinquième couche 760 constituée d'un oxyde, par exemple le même oxyde que celui dont est constituée la première couche 710 ; et
une sixième couche 762, ou couche sacrificielle 762, constituée de silicium polycristallin (poly-Si) ou, de préférence, de silicium amorphe (a-Si).

Plus précisément, la cinquième couche 760 couvre :
les première, deuxième et troisième zones 7160, 7162 et 7164 de la quatrième couche 716 ;
les faces supérieures et les faces latérales libres des premiers espaceurs 730, 732, 734 et 736 ;
la surface supérieure libre du deuxième dépôt 752 ; et
la surface supérieure libre du quatrième dépôt 756.

La sixième couche 762 recouvre intégralement la cinquième couche 760. Cette sixième couche 762 est une couche sacrificielle permettant de protéger des parties de la structure au cours du procédé de réalisation conjointe de la diode à capacité variable 100 et du transistor bipolaire 300.

Les cinquième et sixième couches 760 et 762 ne comblent pas intégralement les première et deuxième ouvertures 720 et 722. En d'autres termes, ces couches 760 et 762 possèdent une épaisseur totale strictement inférieure :
à la moitié de la distance séparant les premiers espaceurs 730 et 732 situés à l'emplacement de la diode ; et
à la moitié de la distance séparant les premiers espaceurs 734 et 736 situés à l'emplacement du transistor.

En d'autres termes, la première ouverture 720 est partiellement comblée par les deux espaceurs 730 et 732 et par les cinquième et sixième couches 760 et 762, formant ainsi une cinquième ouverture 720' correspondant à une ouverture 720 réduite. De la même façon, la deuxième ouverture 722 est partiellement comblée par les deux espaceurs 734 et 736 et par les cinquième et sixième couches 760 et 762, formant ainsi une sixième ouverture 722' correspondant à une ouverture 722 réduite.

Selon ce mode de mise en œuvre, les couches 760 et 762 présentent des épaisseurs différentes. Dans cet exemple :
la cinquième couche 760 possède une épaisseur comprise entre 2 nm et 6 nm, de préférence d'environ 4 nm, plus préférentiellement égale à 4 nm ; et
la sixième couche 762 possède une épaisseur comprise entre 30 nm et 70 nm, de préférence d'environ 50 nm, plus préférentiellement égale à 50 nm.

Les couches 760 et 762 ne sont pas représentées à l'échelle en figure 8.

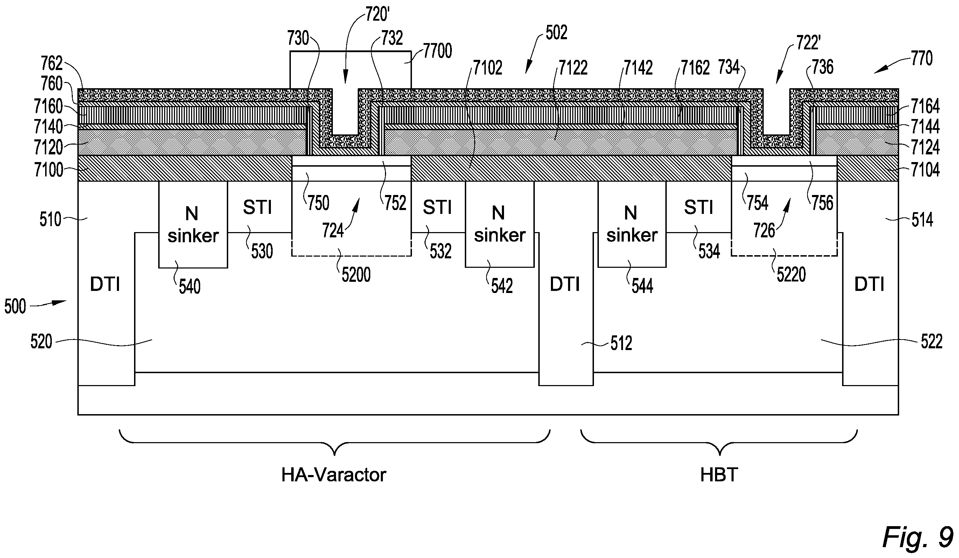

La figure 9 représente, de façon schématique et en coupe, encore une autre étape du mode de mise en œuvre du procédé de réalisation d'une diode varicap, réalisée à partir de la structure telle que décrite en relation avec la figure 8.

Au cours de cette étape, on protège la future diode à capacité variable 100 en vue d'étapes ultérieures. Cette protection est, par exemple, réalisée par :
une première opération consistant à déposer, sur toute la surface supérieure de la sixième couche 762, une septième couche 770 (dont seule la portion 7700 subsiste en fin d'étape et est visible), constituée d'une photorésine de photolithographie, d'une épaisseur suffisante pour combler la cinquième ouverture 720' ;
une deuxième opération consistant à insoler, au travers d'un masque, cette septième couche 770 de photorésine ; et
une troisième opération consistant à éliminer, par gravure, des parties insolées de la septième couche 770 pour ne conserver, à l'emplacement de la diode, qu'une zone 7700 (non insolée) de cette couche 770.

La zone 7700 de la septième couche 770 couvre une zone de la sixième couche 762 située à l'aplomb de la zone 5200 de la première région 520 de collecteur extrinsèque. Cette zone 7700 présente, comme illustré en figure 9, une forme de « T ». Une barre verticale de ce « T » remplit (ou comble) intégralement la cinquième ouverture 720' tandis qu'une barre horizontale de ce « T » s'étend (ou se prolonge) sur des parties de la surface supérieure de la sixième couche 762 adjacentes à la cinquième ouverture 720'.

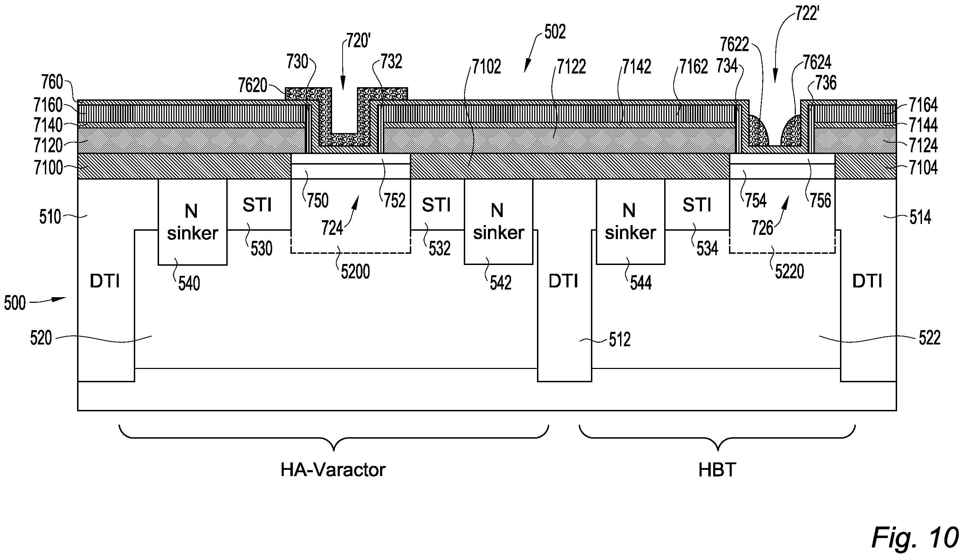

La figure 10 représente, de façon schématique et en coupe, encore une autre étape du mode de mise en œuvre du procédé de réalisation d'une diode varicap, réalisée à partir de la structure telle que décrite en relation avec la figure 9.

Au cours de cette étape, on effectue une opération de gravure, par exemple par un procédé de gravure sèche (gravure au plasma, par exemple), pour éliminer la plupart des zones non protégées de la sixième couche 762. On procède, de préférence, à une gravure anisotrope de sorte que cette gravure fasse préférentiellement (ou sélectivement, ou majoritairement) disparaître des zones horizontales de la sixième couche 762 par rapport à des zones verticales de cette sixième couche 762.

À l'emplacement de la diode, la zone 7700 de la septième couche 770 recouvre les zones verticales de la sixième couche 762 (ces zones sont localisées à l'intérieur de la cinquième ouverture 720' qui se trouve être totalement remplie par la zone 7700). On élimine donc, toujours à l'emplacement de la diode, des zones horizontales de la sixième couche 762 non recouvertes par la zone 7700.

À l'emplacement du transistor, les zones verticales de la sixième couche 762 ne sont pas recouvertes (ces zones sont localisées à l'intérieur de la sixième ouverture 722' qui se trouve être totalement libre). On élimine donc de façon majoritaire toujours à l'emplacement du transistor, des zones horizontales de la sixième couche 762. On élimine aussi, de façon minoritaire, des zones verticales de la sixième couche 762. L'élimination par gravure de la sixième couche 762 est contrôlée de telle sorte que seules deux deuxième et troisième zones 7622 et 7624 de la sixième couche 762 subsistent à l'intérieur de la sixième ouverture 722'.

On retire ensuite la zone 7700 de la septième couche 770. Cette zone 7700 n'est pas représentée en figure 10 car elle est retirée à l'issue de l'étape de gravure ci-dessus.

Comme illustré en figure 10, on ne conserve ainsi, à l'emplacement de la diode, qu'une première zone 7620, ou portion 7620, de la sixième couche 762 située à l'aplomb de la zone 7700 de la septième couche 770. On ne conserve, à l'emplacement du transistor, que les deuxième et troisième zones 7622 et 7624 de la sixième couche 762. Ces deuxième et troisième zones 7622 et 7624 de la sixième couche 762 constituent respectivement deux premières parties 7622 et 7624 de deuxièmes espaceurs 780 et 782 (non visibles en figure 10) à former pour la réalisation du transistor bipolaire 300.

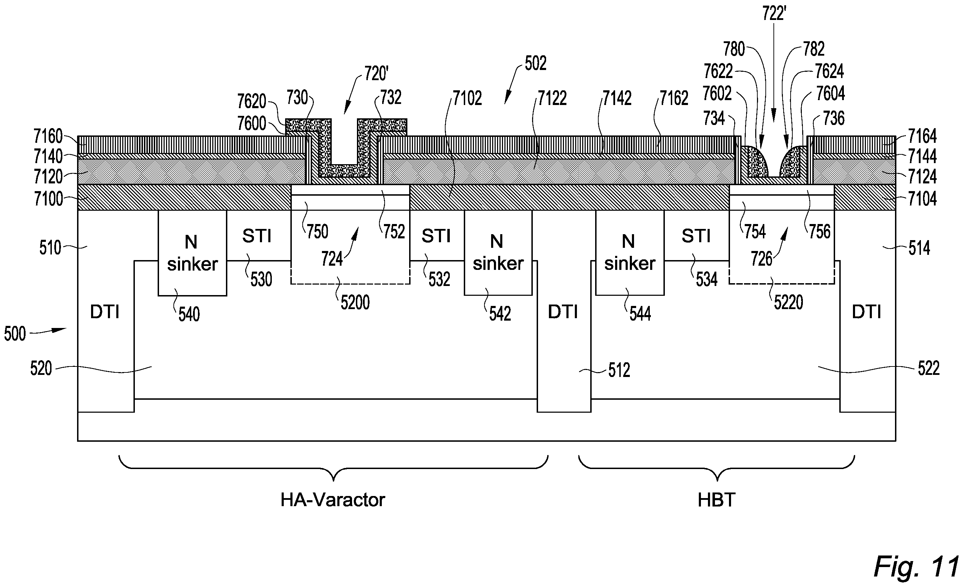

Les premières parties 7622 et 7624 des deuxièmes espaceurs 780 et 782 présentent approximativement, dans l'exemple de la figure 10, une forme de « quart de rond ». Ces parties 7622 et 7624 sont situées de part et d'autre à l'intérieur de la sixième ouverture 722' (en figure 10, la partie 7622 du futur espaceur (780, figure 11) est située du côté gauche à l'intérieur de l'ouverture 722' tandis que la partie 7624 du futur espaceur (782, figure 11) est située du côté droit à l'intérieur de l'ouverture 722'). Les parties 7622 et 7624 sont non jointives, c'est-à-dire qu'elles ne recouvrent que partiellement la surface supérieure libre de la cinquième couche 760 au fond de la sixième ouverture 722'.

Toujours dans l'exemple de la figure 10, les premières parties 7622 et 7624 des espaceurs 780 et 782 sont telles que :
la première partie 7622 de l'espaceur 780 couvre partiellement une paroi verticale interne de la sixième ouverture 722' (en figure 10, la partie 7622 couvre partiellement la paroi gauche de l'ouverture 722') ; et
la première partie 7624 de l'espaceur 782 couvre partiellement l'autre paroi verticale interne de la sixième ouverture 722' (en figure 10, la partie 7624 couvre partiellement la paroi droite de l'ouverture 722').

La figure 11 représente, de façon schématique et en coupe, encore une autre étape du mode de mise en œuvre du procédé de réalisation d'une diode varicap, réalisée à partir de la structure telle que décrite en relation avec la figure 10.

Au cours de cette étape, on élimine des zones de la cinquième couche 760 non recouvertes par les zones restantes de la sixième couche 762. On vient ainsi désoxyder (c'est-à-dire supprimer l'oxyde) des portions des surfaces supérieures des première, deuxième et troisième zones 7160, 7162 et 7164 de la quatrième couche 716. L'oxyde est, de préférence, retiré localement par un procédé de gravure humide.

On conserve ainsi :
une première zone 7600 de la cinquième couche 760 recouverte par la première zone 7620 de la sixième couche 762 ;
une deuxième zone 7602 de la cinquième couche 760 recouverte par la deuxième zone 7622 de la sixième couche 762 ; et
une troisième zone 7604 de la cinquième couche 760 recouverte par la troisième zone 7624 de la sixième couche 762.

Les deuxième et troisième zones 7602 et 7604 de la cinquième couche 760 sont en forme de « L ». Ces deuxième et troisième zones 7602 et 7604 de la cinquième couche 760 constituent respectivement deux deuxièmes parties 7602 et 7604 des deuxièmes espaceurs 780 et 782 pour la réalisation du transistor bipolaire 300. Ainsi, dans l'exemple de la figure 11 :
l'espaceur 780 est constitué d'une première partie 7622 (la deuxième zone 7622 de la sixième couche 762) et d'une deuxième partie 7602 (la deuxième zone 7602 de la cinquième couche 760) ; et
l'espaceur 782 est constitué d'une première partie 7624 (la troisième zone 7624 de la sixième couche 762) et d'une deuxième partie 7604 (la troisième zone 7604 de la cinquième couche 760).

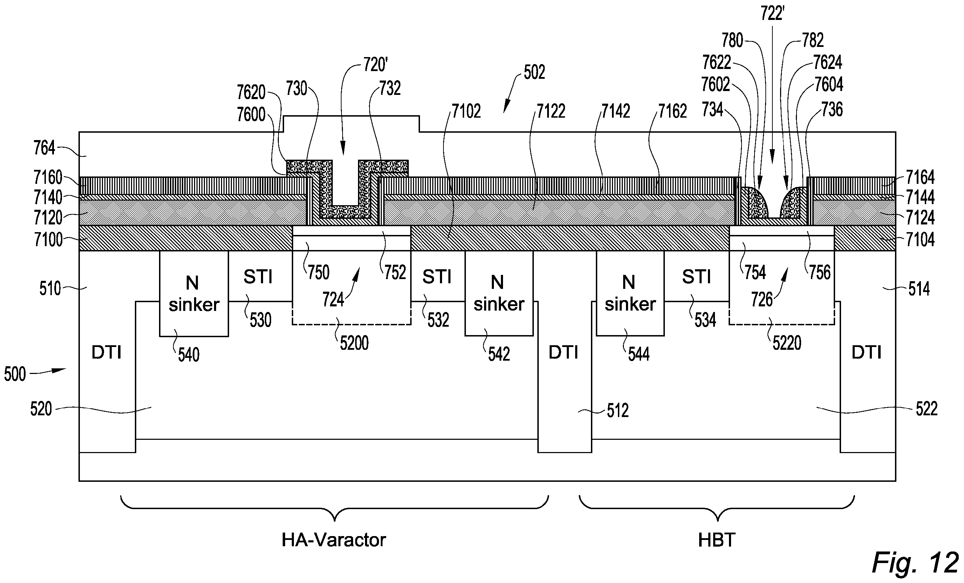

La figure 12 représente, de façon schématique et en coupe, encore une autre étape du mode de mise en œuvre du procédé de réalisation d'une diode varicap, réalisée à partir de la structure telle que décrite en relation avec la figure 11.

Au cours de cette étape, on dépose sur la structure, du côté de la surface supérieure 502 du substrat 500 (en haut, en figure 12), une huitième couche 764 constituée d'un matériau dopé du premier type de conductivité, ici du type n. La huitième couche 764 est, de préférence, constituée du même matériau que celui des premier et troisième dépôts 750 et 754.

Plus précisément, la huitième couche 764 couvre :
les surfaces supérieures libres des première, deuxième et troisième zones 7160, 7162 et 7164 de la quatrième couche 716 ;
les faces supérieures des premiers espaceurs 734 et 736 ;
les faces libres de la première zone 7600 de la cinquième couche 760 ;
les faces libres de la première zone 7620 de la sixième couche 762 ; et
les faces libres des deuxièmes espaceurs 780 et 782, autrement dit les faces libres des deuxième et troisième zones 7602 et 7604 de la cinquième couche 760 ainsi que les faces libres des deuxième et troisième zones 7622 et 7624 de la sixième couche 762.

La huitième couche 764 possède, de préférence, une épaisseur suffisante pour combler (ou remplir) intégralement les cinquième et sixième ouvertures 720' et 722'. Par exemple, la huitième couche 764 possède une épaisseur comprise entre 60 nm et 140 nm, de préférence d'environ 100 nm, plus préférentiellement égale à 100 nm.

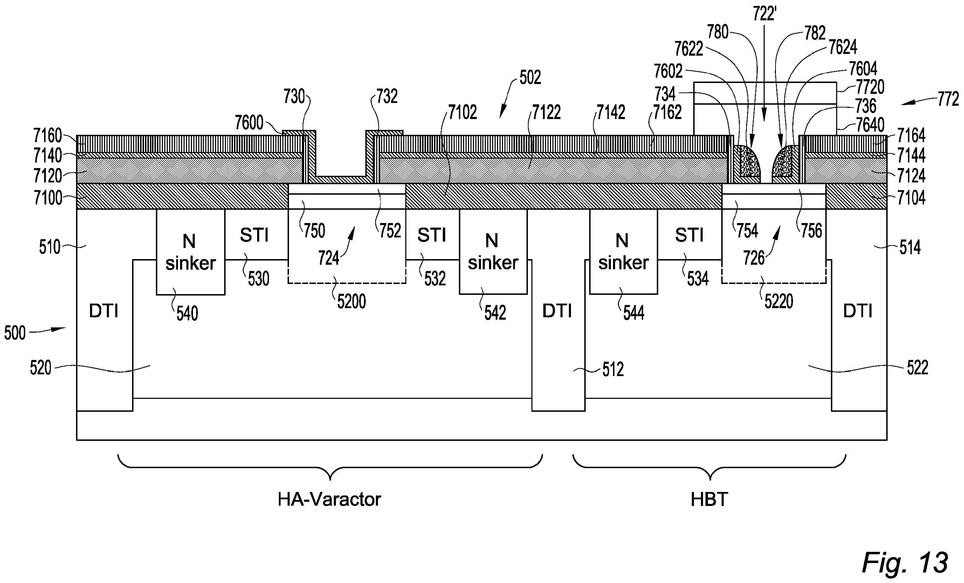

La figure 13 représente, de façon schématique et en coupe, encore une autre étape du mode de mise en œuvre du procédé de réalisation d'une diode varicap, réalisée à partir de la structure telle que décrite en relation avec la figure 12.

Au cours de cette étape, on protège le futur transistor bipolaire 300 en vue d'étapes ultérieures. Cette protection est, par exemple, réalisée par :
une première opération consistant à déposer, sur toute la surface supérieure de la huitième couche 764 (non représentée en figure 13), une neuvième couche 772 (dont seule la portion 7720 subsiste en fin d'étape et est visible), constituée d'une photorésine de photolithographie ;
une deuxième opération consistant à insoler, au travers d'un masque, cette neuvième couche 772 de photorésine ; et
une troisième opération consistant à éliminer, par gravure, des parties insolées de la neuvième couche 772 et à graver la couche 764 pour ne conserver, à l'emplacement du transistor, qu'une zone 7720 (non insolée) de la neuvième couche 772 et une zone 7640 (protégée par la zone 7720) de la huitième couche 764.

La gravure de la huitième couche 764 en vue d'obtenir la zone 7640 s'effectue, par exemple, par un procédé de gravure sèche (gravure au plasma, par exemple). La zone 7640 est sensiblement centrée par rapport à la sixième ouverture 722'. Cette zone 7640 présente, dans cet exemple, une largeur supérieure à celle de la zone 5220 de la deuxième région 522 de collecteur extrinsèque.

Selon ce mode de mise en œuvre, on prolonge l'opération de gravure des couches 772 et 764 jusqu'à éliminer totalement la première zone 7620 (figure 12) de la sixième couche 762. Les deuxième et troisième zones 7622 et 7624 de la sixième couche 762 étant, quant à elles, protégées par la zone 7720 de la neuvième couche 772 et par la zone 7640 de la huitième couche 764, ces zones 7622 et 7624 demeurent intactes à l'issue de la gravure.

La zone 7640 de la huitième couche 764 est connectée au quatrième dépôt 756, c'est-à-dire à la base intrinsèque du transistor bipolaire 300. La zone 7640 est dopée d'un autre type de conductivité que la base intrinsèque 756 (ici, la zone 7640 est du type n tandis que la base 756 est du type p). La zone 7640 de la huitième couche 764 constitue alors un émetteur du transistor bipolaire 300.

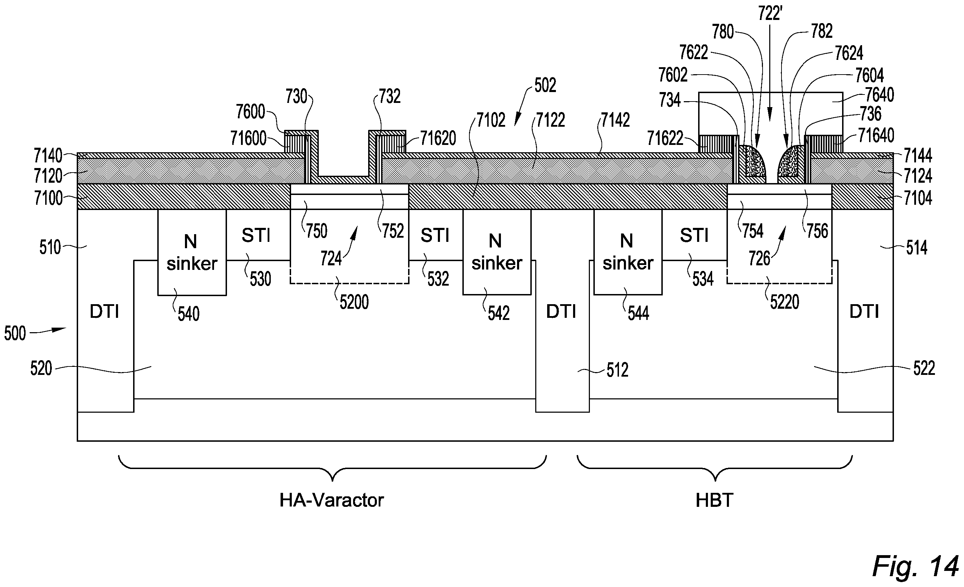

La figure 14 représente, de façon schématique et en coupe, encore une autre étape du mode de mise en œuvre du procédé de réalisation d'une diode varicap, réalisée à partir de la structure telle que décrite en relation avec la figure 13.

Au cours de cette étape, on élimine la zone 7720 de la neuvième couche 772 puis on grave les première, deuxième et troisième zones 7160, 7162 et 7164 de la quatrième couche 716 non recouvertes. On élimine donc, par cette opération de gravure, des portions des zones 7160, 7162 et 7164 qui ne sont protégées ni par la première zone 7600 de la cinquième couche 760, ni par la zone 7640 de la huitième couche 764.

Dans cet exemple, on conserve ainsi uniquement :
une portion 71600 de la première zone 7160 de la quatrième couche 716 située à l'aplomb de la première zone 7600 de la cinquième couche 760 ;
une première portion 71620 de la deuxième zone 7162 de la quatrième couche 716 située à l'aplomb de la première zone 7600 de la cinquième couche 760 ;
une deuxième portion 71622 de la deuxième zone 7162 de la quatrième couche 716 située à l'aplomb de la zone 7640 de la huitième couche 764 ; et
une portion 71640 de la troisième zone 7164 de la quatrième couche 716 située à l'aplomb de la zone 7640 de la huitième couche 764.

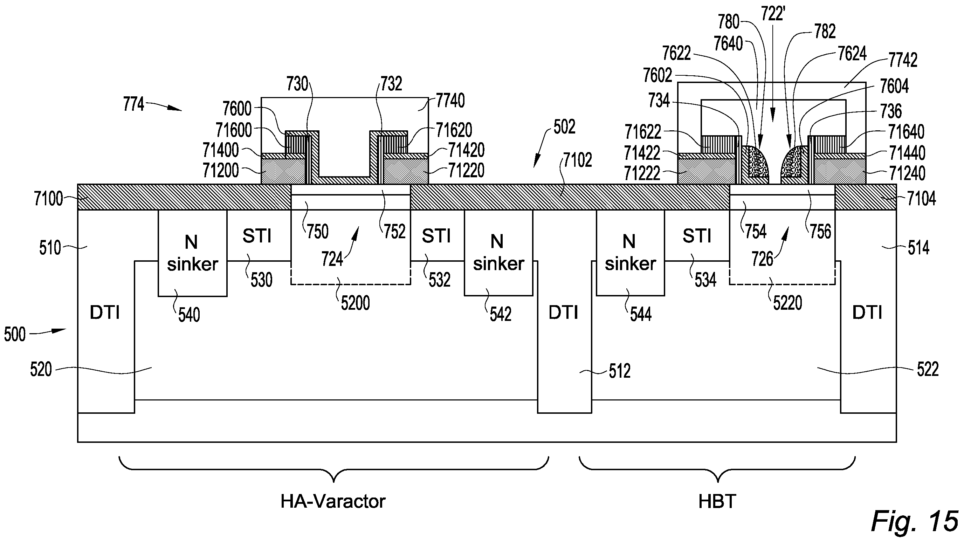

La figure 15 représente, de façon schématique et en coupe, encore une autre étape du mode de mise en œuvre du procédé de réalisation d'une diode varicap, réalisée à partir de la structure telle que décrite en relation avec la figure 14.

Au cours de cette étape, on protège la future diode à capacité variable 100 et le futur transistor bipolaire 300 en vue d'étapes ultérieures. Ces protections sont, par exemple, réalisées par :
une première opération consistant à déposer sur la structure, du côté de la surface supérieure 502 du substrat 500 (en haut, en figure 15), une dixième couche 774 (dont seules les portions 7740 et 7742 subsistent en fin d'étape et sont visibles), constituée d'une photorésine de photolithographie ;
une deuxième opération consistant à insoler, au travers d'un masque, cette dixième couche 774 de photorésine ; et
une troisième opération consistant à éliminer, par gravure, des parties insolées de la dixième couche 774 pour ne conserver que des première et deuxième zones 7740 et 7742 (non insolées) de cette couche 774, à l'emplacement de la diode et à l'emplacement du transistor, respectivement.

En figure 15, seules ces première et deuxième zones 7740 et 7742 de la dixième couche 774 ont été représentées.

La première zone 7740 de la dixième couche 774 couvre, dans cet exemple :
la première zone 7600 de la cinquième couche 760 ;
la face latérale libre de la portion 71600 de la première zone 7160 de la quatrième couche 716 ;
la face latérale libre de la première portion 71620 de la deuxième zone 7162 de la quatrième couche 716 ;
la face supérieure libre d'une portion 71400 de la première zone 7140 de la troisième couche 714 ; et
la face supérieure libre d'une première portion 71420 de la deuxième zone 7142 de la troisième couche 714.

La deuxième zone 7742 de la dixième couche 774 couvre, toujours dans cet exemple :
la zone 7640 de la huitième couche 764 ;
la face latérale libre de la deuxième portion 71622 de la deuxième zone 7162 de la quatrième couche 716 ;
la face latérale libre de la portion 71640 de la troisième zone 7164 de la quatrième couche 716 ;
la face supérieure libre d'une deuxième portion 71422 de la deuxième zone 7142 de la troisième couche 714 ; et
la face supérieure libre d'une portion 71440 de la troisième zone 7144 de la troisième couche 714.

On grave ensuite les zones des deuxième et troisième couches 712 et 714 qui ne sont pas situées à l'aplomb des première et deuxième zones 7740 et 7742 de la dixième couche 774. En d'autres termes, on élimine des portions des zones des deuxième et troisième couches 712 et 714 qui ne sont pas recouvertes par des zones 7740 et 7742.

On conserve ainsi, à l'emplacement de la diode :
la portion 71400 de la première zone 7140 de la troisième couche 714 ;
une portion 71200 de la première zone 7120 de la deuxième couche 712 ;
la première portion 71420 de la deuxième zone 7142 de la troisième couche 714 ; et
une première portion 71220 de la deuxième zone 7122 de la deuxième couche 712.

De la même façon, on conserve ainsi, à l'emplacement du transistor :
la deuxième portion 71422 de la deuxième zone 7142 de la troisième couche 714 ;
une deuxième portion 71222 de la deuxième zone 7122 de la deuxième couche 712 ;
la portion 71440 de la troisième zone 7144 de la troisième couche 714 ; et
une portion 71240 de la troisième zone 7124 de la deuxième couche 712.

Les portions 71222 et 71240 sont connectées au quatrième dépôt 756, c'est-à-dire à la base intrinsèque du transistor bipolaire 300. Ces portions 71222 et 71240, dopées du même type que le quatrième dépôt 756 (ici, du type p), constituent ainsi une base extrinsèque du transistor bipolaire 300.

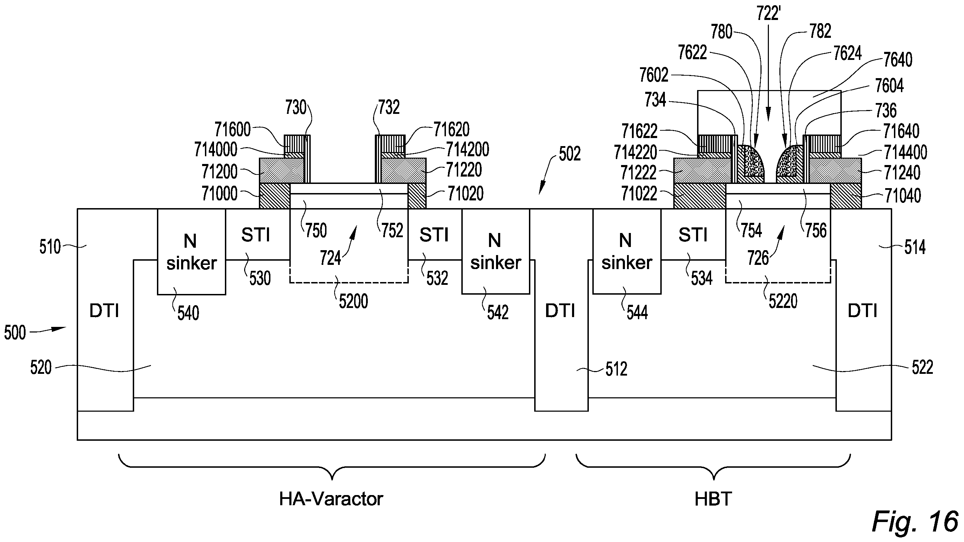

La figure 16 représente, de façon schématique et en coupe, encore une autre étape du mode de mise en œuvre du procédé de réalisation d'une diode varicap, réalisée à partir de la structure telle que décrite en relation avec la figure 15.

Au cours de cette étape, on retire les première et deuxième zones 7740 et 7742 de la dixième couche 774 (ces zones 7740 et 7742 n'ont pas été représentées en figure 16). On élimine ensuite l'oxyde non recouvert, c'est-à-dire des portions des première, deuxième et troisième zones 7100, 7102 et 7104 de la première couche 710 non recouvertes.

Dans l'exemple de la figure 16, on conserve ainsi, à l'emplacement de la diode :
une portion 71000 de la première zone 7100 de la première couche 710, située à l'aplomb de la portion 71200 de la première zone 7120 de la deuxième couche 712 ;
une première portion 71020 de la deuxième zone 7102 de la première couche 710, située à l'aplomb de la première portion 71220 de la deuxième zone 7122 de la deuxième couche 712 ;
un élément 714000 de la portion 71400 de la première zone 7140 de la troisième couche 714, situé à l'aplomb de la portion 71600 de la première zone 7160 de la quatrième couche 716 ; et
un élément 714200 de la première portion 71420 de la deuxième zone 7142 de la troisième couche 714, situé à l'aplomb de la première portion 71620 de la deuxième zone 7162 de la quatrième couche 716.

De la même façon, toujours selon cet exemple, on conserve à l'emplacement du transistor :
une deuxième portion 71022 de la deuxième zone 7102 de la première couche 710, située à l'aplomb de la deuxième portion 71222 de la deuxième zone 7122 de la deuxième couche 712 ;
une portion 71040 de la troisième zone 7104 de la première couche 710, située à l'aplomb de la portion 71240 de la troisième zone 7124 de la deuxième couche 712 ;
un élément 714220 de la deuxième portion 71422 de la deuxième zone 7142 de la troisième couche 714, situé à l'aplomb de la deuxième portion 71622 de la deuxième zone 7162 de la quatrième couche 716 ; et
un élément 714400 de la portion 71440 de la troisième zone 7144 de la troisième couche 714, situé à l'aplomb de la portion 71640 de la troisième zone 7164 de la quatrième couche 716.

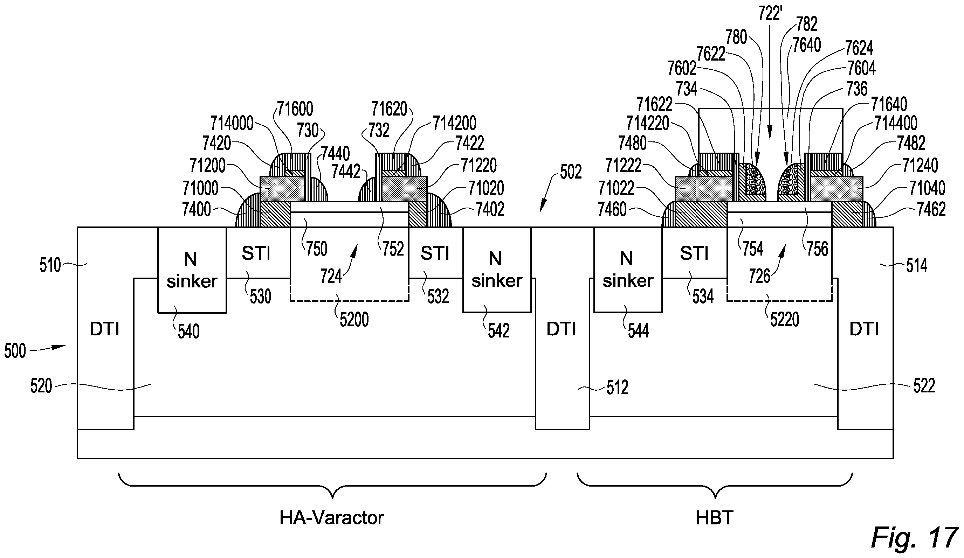

La figure 17 représente, de façon schématique et en coupe, encore une autre étape du mode de mise en œuvre du procédé de réalisation d'une diode varicap, réalisée à partir de la structure telle que décrite en relation avec la figure 16.

Au cours de cette étape, on réalise un dépôt à des emplacements, situés au-dessus de la surface supérieure 502 du substrat 500, qui forment des angles droits. Ce dépôt est constitué de nitrure, par exemple le même nitrure que celui dont est constituée la quatrième couche 716. On forme ainsi des troisièmes espaceurs, appelés « espaceurs MOS » (MOS spacers) .

Dans l'exemple de la figure 17, on forme plus précisément, à l'emplacement de la diode :
un espaceur 7400 comblant partiellement l'angle droit formé par la surface supérieure 502 du substrat 500 et les surfaces latérales libres des portions 71000 et 71200 des premières zones 7100 et 7120 des première et deuxième couches 710 et 712, respectivement ;
un espaceur 7402 comblant partiellement l'angle droit formé par la surface supérieure 502 du substrat 500 et les surfaces latérales libres des premières portions 71020 et 71220 des deuxièmes zones 7102 et 7122 des première et deuxième couches 710 et 712, respectivement ;
un espaceur 7420 comblant partiellement l'angle droit formé par la surface supérieure de la portion 71200 de la première zone 7120 de la deuxième couche 712 et les surfaces latérales libres de l'élément 714000 de la portion 71400 de la première zone 7140 de la troisième couche 714 et de la portion 71600 de la première zone 7160 de la quatrième couche 716 ;
un espaceur 7422 comblant partiellement l'angle droit formé par la surface supérieure de la première portion 71220 de la deuxième zone 7122 de la deuxième couche 712 et les surfaces latérales libres de l'élément 714200 de la première portion 71420 de la deuxième zone 7142 de la troisième couche 714 et de la première portion 71620 de la deuxième zone 7162 de la quatrième couche 716 ;
un espaceur 7440 comblant partiellement l'angle droit formé par la surface supérieure du deuxième dépôt 752 et par la surface latérale libre de l'espaceur 730 ; et
un espaceur 7442 comblant partiellement l'angle droit formé par la surface supérieure du deuxième dépôt 752 et par la surface latérale libre de l'espaceur 732.

Toujours dans l'exemple de la figure 17, on forme plus précisément, à l'emplacement du transistor :
un espaceur 7460 comblant partiellement l'angle droit formé par la surface supérieure 502 du substrat 500 et par les surfaces latérales libres des deuxièmes portions 71022 et 71222 des deuxièmes zones 7102 et 7122 des première et deuxième couches 710 et 712, respectivement ;
un espaceur 7462 comblant partiellement l'angle droit formé par la surface supérieure 502 du substrat 500 et par les surfaces latérales libres des portions 71040 et 71240 des troisièmes zones 7104 et 7124 des première et deuxième couches 710 et 712, respectivement ;
un espaceur 7480 comblant partiellement l'angle droit formé par la surface supérieure de la deuxième portion 71222 de la deuxième zone 7122 de la deuxième couche 712 et les surfaces latérales libres de l'élément 714220 de la deuxième portion 71422 de la deuxième zone 7142 de la troisième couche 714 et la deuxième portion 71622 de la deuxième zone 7162 de la quatrième couche 716 ; et
un espaceur 7482 comblant partiellement l'angle droit formé par la surface supérieure de la portion 71240 de la troisième zone 7124 de la deuxième couche 712 et par les surfaces latérales libres de l'élément 714400 de la portion 71440 de la troisième zone 7144 de la troisième couche 714 et de la portion 71640 de la troisième zone 7164 de la quatrième couche 716.

Les espaceurs MOS 7400, 7402, 7420, 7422, 7440, 7442, 7460, 7462, 7480 et 7482 présentent approximativement, en figure 17, une forme de « quart de rond ». Ces espaceurs MOS 7400, 7402, 7420, 7422, 7440, 7442, 7460, 7462, 7480 et 7482 ne sont pas représentés à l'échelle en figure 17.

À l'emplacement de la diode, dans l'exemple de la figure 17 :
l'espaceur 7400 couvre partiellement la surface supérieure de la tranchée d'isolation peu profonde 530, couvre totalement la surface latérale libre de la portion 71000 et couvre partiellement la surface latérale libre de la portion 71200 ;
l'espaceur 7402 couvre partiellement la surface supérieure de la tranchée d'isolation peu profonde 532, couvre totalement la surface latérale libre de la portion 71020 et couvre partiellement la surface latérale libre de la portion 71220 ;
l'espaceur 7420 couvre partiellement la surface supérieure de la portion 71200, couvre totalement la surface latérale libre de l'élément 714000 et couvre partiellement la surface latérale libre de la portion 71600 ;
l'espaceur 7422 couvre partiellement la surface supérieure de la portion 71220, couvre totalement la surface latérale libre de l'élément 714200 et couvre partiellement la surface latérale libre de la portion 71620 ;
l'espaceur 7440 couvre partiellement la surface supérieure du deuxième dépôt 752 et couvre partiellement la surface latérale libre de l'espaceur 730 ; et
l'espaceur 7442 couvre partiellement la surface supérieure du deuxième dépôt 752 et couvre partiellement la surface latérale libre de l'espaceur 732.

À l'emplacement du transistor, toujours dans l'exemple de la figure 17 :
l'espaceur 7460 couvre partiellement la surface supérieure de la tranchée d'isolation peu profonde 534 et couvre partiellement la surface latérale libre de la portion 71022 ;
l'espaceur 7462 couvre partiellement la surface supérieure de la tranchée d'isolation profonde 514 et couvre partiellement la surface latérale libre de la portion 71040 ;
l'espaceur 7480 couvre partiellement la surface supérieure de la portion 71222, couvre totalement la surface latérale libre de l'élément 714220 et couvre partiellement la surface latérale libre de la portion 71622 ; et
l'espaceur 7482 couvre partiellement la surface supérieure de la portion 71240, couvre totalement la surface latérale libre de l'élément 714400 et couvre partiellement la surface latérale libre de la portion 71640.

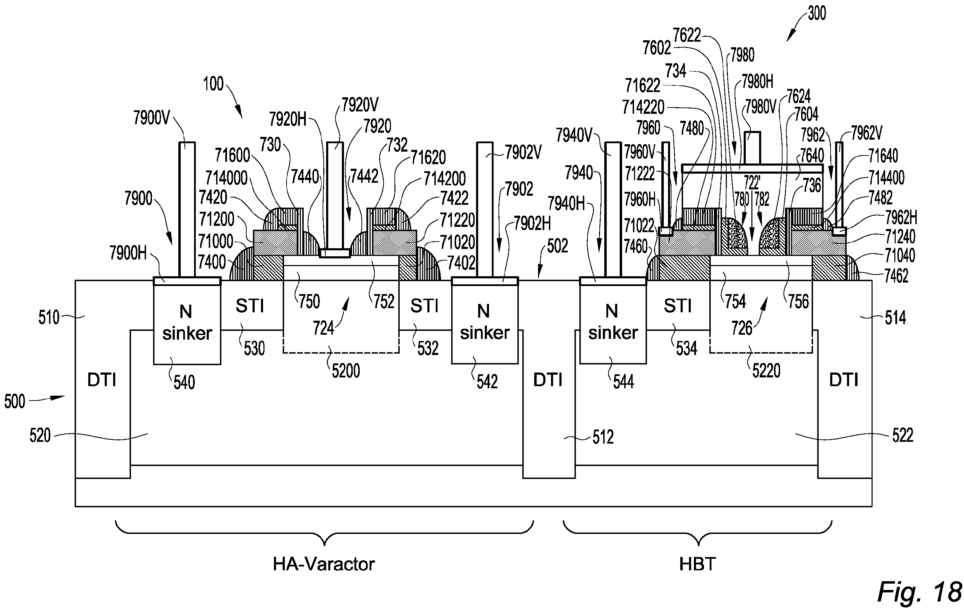

La figure 18 représente, de façon schématique et en coupe, encore une autre étape du mode de mise en œuvre du procédé de réalisation d'une diode varicap, réalisée à partir de la structure telle que décrite en relation avec la figure 17.

Au cours de cette étape, on réalise des éléments de reprise de contact de la diode à capacité variable 100 et du transistor bipolaire 300. Ces éléments de reprise de contact sont, par exemple, obtenus par siliciuration des surfaces horizontales libres de la structure qui n'appartiennent pas à des tranchées d'isolation profondes ou peu profondes.

Plus particulièrement, à l'emplacement de la diode :
un élément de reprise de contact 7900 est formé au droit du premier puits 540 ;
un élément de reprise de contact 7902 est formé au droit du deuxième puits 542 ; et
un élément de reprise de contact 7920 est formé au droit de la zone 5200 de la première région 520 de collecteur extrinsèque.

L'élément de reprise de contact 7900 est constitué d'une portion horizontale 7900H, recouvrant totalement la surface supérieure du premier puits 540, et d'une portion verticale 7900V. L'élément de reprise de contact 7902 est constitué d'une portion horizontale 7902H, recouvrant totalement la surface supérieure du deuxième puits 542, et d'une portion verticale 7902V. L'élément de reprise de contact 7920 est constitué d'une portion horizontale 7920H, recouvrant la surface supérieure libre du deuxième dépôt 752, et d'une portion verticale 7920V.

De la même façon, à l'emplacement du transistor :
un élément de reprise de contact 7940 est formé au droit du troisième puits 544 ;
un élément de reprise de contact 7960 est formé au droit de la surface supérieure libre de la deuxième portion 71222 de la deuxième zone 7122 de la deuxième couche 712 ;
un élément de reprise de contact 7962 est formé au droit de la surface supérieure libre de la portion 71240 de la troisième zone 7124 de la deuxième couche 712 ; et
un élément de reprise de contact 7980 est formé au droit de la zone 7640 de la huitième couche 764.

L'élément de reprise de contact 7940 est constitué d'une portion horizontale 7940H, recouvrant totalement la surface supérieure du troisième puits 544, et d'une portion verticale 7940V. L'élément de reprise de contact 7960 est constitué d'une portion horizontale 7960H, recouvrant totalement la surface supérieure libre de la portion 71222, et d'une portion verticale 7960V. L'élément de reprise de contact 7962 est constitué d'une portion horizontale 7962H, recouvrant totalement la surface supérieure libre de la portion 71240, et d'une portion verticale 7962V. L'élément de reprise de contact 7980 est constitué d'une portion horizontale 7980H, recouvrant totalement la surface supérieure de la zone 7640, et d'une portion verticale 7980V.

Les portions verticales respectives 7900V, 7902V, 7920V, 7940V, 7960V, 7962V et 7980V des éléments de reprise de contact 7900, 7902, 7920, 7940, 7960, 7962 et 7980 sont sensiblement perpendiculaires aux portions horizontales 7900H, 7902H, 7920H, 7940H, 7960H, 7962H et 7980H et approximativement centrées par rapport à ces mêmes portions horizontales. En d'autres termes, les éléments de reprise de contact 7900, 7902, 7920, 7940, 7960, 7962 et 7980 ont une forme de « T » renversé.

À l'emplacement de la diode, les éléments de reprise de contact 7900 et 7902 sont tous deux connectés, respectivement par les premier et deuxième puits 540 et 542, à la première région 520 de collecteur extrinsèque. Cette première région 520 de collecteur extrinsèque est elle-même, par sa zone 5200, connectée au premier dépôt 750. Dans l'exemple où le premier dépôt 750 est dopé du type n, les éléments de reprise de contact 7900 et 7902 constituent donc des contacts (ou des bornes) de cathode de la diode varicap 100.

L'élément de reprise de contact 7920 est directement connecté au deuxième dépôt 752. Dans l'exemple où le deuxième dépôt 752 est dopé du type p, l'élément de reprise de contact 7920 constitue donc un contact (ou une borne) d'anode de la diode varicap 100.

À l'emplacement du transistor, l'élément de reprise de contact 7940 est connecté, par le troisième puits 544, à la deuxième région 522 de collecteur extrinsèque. Cette deuxième région 522 de collecteur extrinsèque est elle-même, par sa zone 5220, connectée au troisième dépôt 754 qui constitue le collecteur intrinsèque du transistor bipolaire 300. L'élément de reprise de contact 7940 constitue donc un contact (ou une borne) de collecteur du transistor bipolaire 300.

Les éléments de reprise de contact 7960 et 7962 sont respectivement connectés à la deuxième portion 71222 de la deuxième zone 7122 de la deuxième couche 712 et à la portion 71240 de la troisième zone 7124 de la deuxième couche 712. Ces portions 71222 et 71240, qui constituent la base extrinsèque du transistor bipolaire 300, sont elles-mêmes connectées au quatrième dépôt 756 qui constitue la base intrinsèque du transistor bipolaire 300. Les éléments de reprise de contact 7960 et 7962 constituent donc des contacts (ou des bornes) de base du transistor bipolaire 300.

L'élément de reprise de contact 7980 est directement connecté à la zone 7640 de la huitième couche 764, qui constitue l'émetteur du transistor bipolaire 300. L'élément de reprise de contact 7980 constitue donc un contact (ou une borne) d'émetteur du transistor bipolaire 300.

Le mode de mise en œuvre du procédé dont les étapes successives ont été décrites en relation avec les figures 1 à 18 présente l'avantage de permettre de réaliser, en même temps (de façon conjointe), la diode à capacité variable 100 et le transistor bipolaire 300. Cela réduit donc le nombre d'étapes de fabrication de la diode 100 et du transistor 300 par rapport à un procédé selon lequel la diode 100 et le transistor 300 seraient réalisés séparément, l'un après l'autre.

Un autre avantage du mode de mise en œuvre décrit ci-dessus réside dans le fait que les dépôts 750, 752, 754 et 756 (ou les dépôts 752' et 756' dans le cas de la variante exposée en relation avec la figure 7) sont, de préférence, obtenus par épitaxie (par croissance épitaxiale). Cela permet ainsi aux premier et deuxième dépôts 750 et 752 (ou à la zone 5200 de la première région 520 de collecteur extrinsèque et au dépôt 752' dans le cas de la variante) de former une jonction p-n présentant une interface très marquée, c'est-à-dire au voisinage de laquelle le profil de dopant varie de façon très importante. On obtient ainsi un varactor 100 à jonction p-n dite « hyperabrupte », désigné par le terme de « varactor hyperabrupt » (hyperabrupt varactor). En d'autres termes, la diode varicap 100 est une diode à capacité variable dotée d'un profil de dopants abrupt au voisinage de l'interface de sa jonction p-n.

Une ou plusieurs diodes à capacité variable 100 et un ou plusieurs transistors bipolaires 300 tels que décrits peuvent ainsi être fabriqués afin de réaliser un circuit électronique.

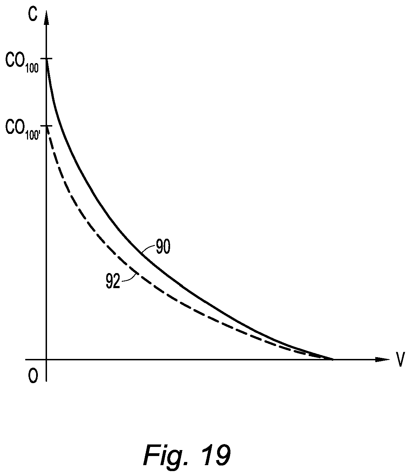

La figure 19 représente des courbes de variation d'une grandeur caractéristique des diodes varicap obtenues selon le mode de mise en œuvre du procédé tel que décrit.

La figure 19 traduit des variations de la capacité électrique, notée C, de diodes varicap en fonction d'une tension, notée V, de polarisation inverse appliquée entre leur anode (borne 7920 en figure 18) et leur cathode (bornes 7900 et 7902 en figure 18).

Dans l'exemple de la figure 19 :
une première courbe 90 en trait plein illustre, en fonction de la tension de polarisation V, la variation de capacité C de la diode 100 dont la jonction p-n est formée, comme exposé en relation avec la figure 6, par les premier et deuxième dépôts 750 et 752, ces dépôts 750 et 752 étant préférentiellement tous deux épitaxiés ; et
une deuxième courbe 92 en trait pointillé illustre, en fonction de la tension de polarisation V, la variation de capacité C d'une autre diode (non représentée) comportant une jonction p-n formée, comme dans le cas de la variante exposée en relation avec la figure 7, par le cinquième dépôt 752' et par la zone 5200 de la première région 520 de collecteur extrinsèque, ce cinquième dépôt 752' étant préférentiellement épitaxié.

Pour une tension V de polarisation nulle, les inventeurs ont constaté que la diode 100 présentait une capacité électrique, notée C0₁₀₀, supérieure à la capacité électrique, notée C0_{100'}, de la diode comportant une jonction p-n formée, comme dans le cas de la variante exposée en relation avec la figure 7, par le cinquième dépôt 752' et par la zone 5200 de la première région 520 de collecteur extrinsèque. Ce phénomène semble s'expliquer par la présence, dans la diode 100, du premier dépôt 750 intercalé entre le deuxième dépôt 752 et la zone 5200 de la première région 520 de collecteur extrinsèque. De manière générale, la présence du premier dépôt 750 dans le cas de la diode 100 permet d'obtenir une capacité électrique plus élevée que celle de la diode dépourvue du dépôt 750.

Divers modes de réalisation, modes de mise en œuvre et variantes ont été décrits. L'homme de l'art comprendra que certaines caractéristiques de ces divers modes de réalisation, modes de mise en œuvre et variantes pourraient être combinées, et d'autres variantes apparaîtront à l'homme de l'art. En particulier, ce qui a été précédemment décrit en relation avec les figures 1 à 18 prend pour exemple un mode de mise en œuvre d'un procédé de réalisation conjointe (ou co-intégration) d'un transistor bipolaire de type NPN et d'une diode à capacité variable. Toutefois, les types de conductivité (les dopages) pris pour exemple dans la présente description peuvent être modifiés (ou inversés). En particulier, l'adaptation de ce mode de mise en œuvre à un procédé de réalisation conjointe d'un transistor bipolaire de type PNP et d'une diode à capacité variable est à la portée de l'homme du métier à partir des indications fournies ci-dessus.

Enfin, la mise en œuvre pratique des modes de réalisation, modes de mise en œuvre et variantes décrits est à la portée de l'homme du métier à partir des indications fonctionnelles données ci-dessus. En particulier, la fabrication du substrat 500 utilisé pour la mise en œuvre du procédé exposé en relation avec les figures 1 à 18 est à la portée de l'homme du métier. Les opérations de dépôt, de masquage et de gravure sont également à la portée de l'homme du métier à partir des indications ci-dessus.

## Revendications

1. Procédé de réalisation, conjointement sur un même substrat (500), d'au moins un transistor bipolaire (300) et d'au moins une diode à capacité variable (100), le procédé comprenant, préalablement à la formation d'un émetteur (7640) dudit transistor bipolaire, une étape de revêtement de ladite diode à capacité variable par une portion (7620) d'une couche sacrificielle (762).

2. Procédé selon la revendication 1, dans lequel ladite diode (100) comporte une jonction p-n incluant :
une première région (520) d'un premier type de conductivité ; et
une deuxième région (752 ; 752') d'un deuxième type de conductivité,
ladite deuxième région (752 ; 752') et une base intrinsèque (754 ; 754') dudit transistor (300) étant réalisées au cours d'une même étape.

3. Procédé selon la revendication 2, dans lequel ladite deuxième région (752 ; 752') est réalisée à l'aplomb d'une région de collecteur extrinsèque (520) constituant ladite première région.

4. Procédé selon la revendication 2 ou 3, dans lequel ladite deuxième région (752 ; 752') est réalisée par épitaxie.

5. Procédé selon l'une quelconque des revendications 2 à 4, dans lequel ladite diode (100) comporte une troisième région (750), du premier type de conductivité, intercalée entre ladite première région (520) et ladite deuxième région (752).

6. Procédé selon la revendication 5, dans lequel ladite troisième région (750) et un collecteur intrinsèque (754) dudit transistor (300) sont réalisés au cours d'une même étape.

7. Procédé selon la revendication 5 ou 6, dans lequel ladite troisième région (750) est réalisée par épitaxie.

8. Procédé selon l'une quelconque des revendications 2 à 7, dans lequel le premier type de conductivité est n et le deuxième type de conductivité est p.

9. Procédé selon l'une quelconque des revendications 2 à 7, dans lequel le premier type de conductivité est p et le deuxième type de conductivité est n.

10. Procédé selon l'une quelconque des revendications 1 à 9, dans lequel ladite diode (100) est un varactor à jonction p-n hyperabrupte.

11. Procédé selon l'une quelconque des revendications 1 à 10, comportant des étapes consistant à :
prévoir un substrat (500), à l'intérieur duquel au moins une première région (520) de collecteur extrinsèque comporte des premier et deuxième puits (540, 542) et à l'intérieur duquel au moins une deuxième région (522) de collecteur extrinsèque comporte un troisième puits (544) ;
former un empilement (700) comportant, à partir d'une surface supérieure (502) dudit substrat (500), des première, deuxième, troisième et quatrième couches (710, 712, 714, 716) ;
pratiquer des première et deuxième ouvertures (720, 722) dans lesdites deuxième, troisième et quatrième couches (712, 714, 716) ;
réaliser des premiers espaceurs (730, 732, 734, 736) à l'intérieur desdites première et deuxième ouvertures (720, 722) ; et
pratiquer des troisième et quatrième ouvertures (724, 726) dans ladite première couche (710).

12. Procédé selon la revendication 11, comportant des étapes consistant à :
déposer, du côté de ladite surface supérieure (502), une cinquième couche (760) et ladite couche sacrificielle (762) ;
protéger ladite portion (7620) de ladite couche sacrificielle (762) par une zone (7700) d'une sixième couche (770) ;
éliminer ladite couche sacrificielle (762) à l'exception de ladite portion (7620) de ladite couche sacrificielle (762) et à l'exception de première et deuxième zones (7622, 7624) de ladite couche sacrificielle (762) ;
éliminer ladite zone (7700) de ladite sixième couche (770) ;
éliminer des zones de ladite cinquième couche (760) non recouvertes ;
déposer, du côté de ladite surface supérieure (502), une septième couche (764) ;
éliminer ladite septième couche (764) à l'exception d'une zone (7640) de ladite septième couche (764) recouverte par une zone (7720) d'une huitième couche (772) et éliminer ladite portion (7620) de ladite couche sacrificielle (762) ;
éliminer des portions de zones (7160, 7162, 7164) de ladite quatrième couche (716) non recouvertes et éliminer ladite zone (7720) de ladite huitième couche (772) ;
protéger respectivement la future diode (100) et le futur transistor (300) par des première et deuxième zones (7740, 7742) d'une neuvième couche (774) et éliminer des portions non protégées de première, deuxième et troisième zones (7140, 7142, 7144, 7120, 7122, 7124) desdites troisième et deuxième couches (714, 712) ;
éliminer des portions de zones (7100, 7102, 7104) de ladite première couche (710) non recouvertes et éliminer lesdites première et deuxième zones (7740, 7742) de ladite neuvième couche (774) ;
réaliser des deuxièmes espaceurs (7400, 7402, 7420, 7422, 7440, 7442, 7460, 7462, 7480, 7482) comblant des angles droits du côté de ladite surface supérieure (502) ; et
réaliser respectivement des premier, deuxième et troisième contacts (7900, 7902, 7940) sur lesdits premier, deuxième et troisième puits (540, 542, 544), réaliser un troisième contact sur un premier dépôt (752 ; 752'), réaliser un quatrième contact sur une première portion (71222) de ladite zone (7122) de ladite deuxième couche (712), réaliser un cinquième contact sur une deuxième portion (71240) de ladite zone (7122) de ladite deuxième couche (712) et réaliser un sixième contact sur ladite zone (7640) de ladite septième couche (764).

13. Procédé selon la revendication 11 ou 12, comportant une étape consistant à combler ladite troisième ouverture (724) par un deuxième dépôt (750) et par ledit premier dépôt (752) et à combler ladite quatrième ouverture (726) par des troisième et quatrième dépôts (754, 756).

14. Procédé selon la revendication 11 ou 12, comportant une étape consistant à combler ladite troisième ouverture (724) par ledit premier dépôt (752') et à combler ladite quatrième ouverture (726) par un cinquième dépôt (756').

15. Circuit électronique comportant au moins une diode à capacité variable (100) et au moins un transistor bipolaire (300), obtenus par le procédé selon l'une quelconque des revendications 1 à 14.
